# EUROPEAN PATENT APPLICATION

(11) **EP 4 797 532 A1**
(43) Date of publication of application: **26.08.2026**
(21) Application number: 24887636.9
(22) Date of filing: 14.09.2024
(51) Int. Cl.: H03F 3/21

(54) **MULTI-CHANNEL POWER AMPLIFICATION ARCHITECTURE, RADIO FREQUENCY GENERATION DEVICE AND COMMUNICATION SYSTEM**

(30) Priority: 09.11.2023 CN 202311492080
(71) Applicant: HUAWEI TECHNOLOGIES CO., LTD., Shenzhen 518129 (CN)
(72) Inventor: SUN, Jie, Shenzhen, Guangdong 518129 (CN); ZENG, Zhixiong, Shenzhen, Guangdong 518129 (CN); LI, Song, Shenzhen, Guangdong 518129 (CN); HE, Xuan, Shenzhen, Guangdong 518129 (CN); YANG, Maoqing, Shenzhen, Guangdong 518129 (CN)
(74) Representative: Goddar, Heinz J.
(86) International application number: PCT/CN2024/119222
(87) International publication number: WO 2025/098018

(57) **Abstract**

Embodiments of this application provide a multi-way power amplification architecture, a radio frequency generation device, and a communication system, and are applied to the field of wireless communication technologies. The multi-way power amplification architecture includes a multi-way amplification circuit and a first inter-frequency power division circuit. The multi-way amplification circuit is configured to separately output a first radio frequency signal and/or a second radio frequency signal. The first inter-frequency power division circuit includes at least one microstrip line. The first inter-frequency power division circuit performs power combination on a plurality of first radio frequency signals and/or second radio frequency signals based on an impedance characteristic of the microstrip line, and separately outputs a power-combined signal of the first radio frequency signal and a power-combined signal of the second radio frequency signal by using an inter-frequency power division function. In embodiments of this application, power combination and inter-frequency power division are implemented based on an inter-frequency power division structure including a microstrip line, to avoid a design limitation, an insertion loss, and the like that are caused by a bridge structure. The embodiments facilitate design of a power amplifier with a large bandwidth, a large backoff amount, high efficiency, and a plurality of bands.

## Description

This application claims priority to Chinese Patent Application No. 202311492080.2, filed with the China National Intellectual Property Administration on November 9, 2023 and entitled "MULTI-WAY POWER AMPLIFICATION ARCHITECTURE, RADIO FREQUENCY GENERATION DEVICE, AND COMMUNICATION SYSTEM", which is incorporated herein by reference in its entirety.

### TECHNICAL FIELD

This application relates to the field of wireless communication technologies, and in particular, to a multi-way power amplification architecture, a radio frequency generation device, and a communication system.

### BACKGROUND

In application of wireless communication technologies, data information is carried on a radio frequency signal by using a modulation technology, and wireless communication between a transmitter side and a receiver side is implemented by transmitting the radio frequency signal. To ensure communication quality of wireless communication, before the radio frequency signal is transmitted, power amplification usually needs to be performed on the radio frequency signal. However, as wireless communication technologies evolve, the modulation technology of the radio frequency signal becomes increasingly complex, resulting in an increase in a signal peak-to-average ratio of an output radio frequency signal. In such cases, to improve operating efficiency of the output radio frequency signal, a power amplifier needs to have a power backoff amount.

As communication systems evolve toward higher rates and lower latency, a bandwidth of a communication signal continues to increase. Because bands of communication signals are fragmented, power amplifiers usually need to be designed to support concurrency across a plurality of different bands. In a power amplifier design, improving backoff efficiency and extending an operating bandwidth are conflicting requirements, and both present design challenges. Therefore, how to design a power amplifier with a large backoff amount, high efficiency, and a large power bandwidth remains challenging.

### SUMMARY

Embodiments of this application provide a multi-way power amplification architecture, a radio frequency generation device, and a communication system, to implement a power amplification design with a large backoff amount, high efficiency, and a large bandwidth.

To achieve the foregoing objectives, the following technical solutions are used in embodiments of this application.

According to a first aspect, a multi-way power amplification architecture is provided. The multi-way power amplification architecture includes a first main amplification circuit, a second main amplification circuit, a first auxiliary amplification circuit, a second auxiliary amplification circuit, and a first inter-frequency power division circuit. The first inter-frequency power division circuit includes at least one microstrip line. An output port of the first main amplification circuit, an output port of the second main amplification circuit, an output port of the first auxiliary amplification circuit, and an output port of the second auxiliary amplification circuit are separately coupled to the first inter-frequency power division circuit. The output port of the first main amplification circuit is configured to output a first radio frequency signal, and the output port of the second main amplification circuit is configured to output a second radio frequency signal. The first radio frequency signal and the second radio frequency signal have different frequencies. The output port of the first auxiliary amplification circuit and the output port of the second auxiliary amplification circuit are configured to output a radio frequency frequency-combined signal, and the radio frequency frequency-combined signal includes the first radio frequency signal and/or the second radio frequency signal. A first output port of the first inter-frequency power division circuit is configured to assist in implementing power combination of the first radio frequency signal. A second output port of the first inter-frequency power division circuit is configured to assist in implementing power combination of the second radio frequency signal.

In this embodiment of this application, the first inter-frequency power division circuit is separately coupled to the first main amplification circuit, the second main amplification circuit, the first auxiliary amplification circuit, and the second auxiliary amplification circuit, to assist in implementing power combination of the first radio frequency signal and power combination of the second radio frequency signal, and output a first radio frequency combined signal and a second radio frequency combined signal based on an inter-frequency power division function. The first main amplification circuit may perform power amplification on a radio frequency signal of a first band, to obtain the first radio frequency signal, and the second main amplification circuit may perform power amplification on a radio frequency signal of a second band, to obtain the second radio frequency signal. The first auxiliary amplification circuit and the second auxiliary amplification circuit may perform power amplification on the radio frequency signal of the first band and/or the second band, to separately obtain one radio frequency combined signal that may include the first radio frequency signal and/or the second radio frequency signal. The first inter-frequency power division circuit may distinguish the first radio frequency signal and the second radio frequency signal based on the inter-frequency power division function, and assist in implementing power combination of the first radio frequency signals output by the first main amplification circuit, the first auxiliary amplification circuit, and the second auxiliary amplification circuit, and may also assist in implementing power combination of the second radio frequency signals output by the second main amplification circuit, the first auxiliary amplification circuit, and the second auxiliary amplification circuit. The multi-way power amplification architecture in this embodiment of this application implements load-pull and inter-frequency power division based on a first inter-frequency power division circuit, to avoid a design difficulty caused by an impedance characteristic of a bridge when the bridge is used for inter-frequency power division, and improve design flexibility of the architecture. In addition, the microstrip line reduces device area overheads and improves device integration.

In some possible implementations, the first inter-frequency power division circuit includes a first inter-frequency power division subcircuit, a second inter-frequency power division subcircuit, and a connecting microstrip line. The first inter-frequency power division subcircuit is coupled to the second inter-frequency power division subcircuit through the connecting microstrip line. The first inter-frequency power division subcircuit and the second inter-frequency power division circuit are connected in different manners, and may implement inter-frequency power division effect in different manners. Specifically, the following three connection relationships may be used as examples:

Example 1 of a connection relationship: A first end of the connecting microstrip line is coupled to a combining port of the first inter-frequency power division subcircuit, and a second end of the connecting microstrip line is coupled to a combining port of the second inter-frequency power division subcircuit. The output port of the first auxiliary amplification circuit is coupled to the combining port of the first inter-frequency power division subcircuit. The output port of the first main amplification circuit is coupled to a first division port of the first inter-frequency power division subcircuit, and a second division port of the first inter-frequency power division subcircuit is the second output port of the first inter-frequency power division circuit. The output port of the second auxiliary amplification circuit is coupled to the combining port of the second inter-frequency power division subcircuit. The output port of the second main amplification circuit is coupled to a first division port of the second inter-frequency power division subcircuit, and a second division port of the second inter-frequency power division subcircuit is the first output port of the first inter-frequency power division circuit.

For example, the first inter-frequency power division subcircuit includes a first microstrip line, a second microstrip line, a first isolation circuit, and a second isolation circuit. The second inter-frequency power division subcircuit includes a third microstrip line, a fourth microstrip line, a third isolation circuit, and a fourth isolation circuit. A first end of the first microstrip line and a first end of the second microstrip line are coupled to form the combining port of the first inter-frequency power division subcircuit, a second end of the first microstrip line is used as the first division port of the first inter-frequency power division subcircuit, and a second end of the second microstrip line is used as the second division port of the first inter-frequency power division subcircuit. A first end of the third microstrip line and a first end of the fourth microstrip line are coupled to form the combining port of the second inter-frequency power division subcircuit, a second end of the third microstrip line is used as the first division port of the second inter-frequency power division subcircuit, and a second end of the fourth microstrip line is used as the second division port of the second inter-frequency power division subcircuit. The first isolation circuit is coupled to the first division port of the first inter-frequency power division subcircuit. The second isolation circuit is coupled to the second division port of the first inter-frequency power division subcircuit. The third isolation circuit is coupled to the first division port of the second inter-frequency power division subcircuit. The fourth isolation circuit is coupled to the second division port of the second inter-frequency power division subcircuit. The first isolation circuit presents a short-circuit characteristic to the second radio frequency signal, and presents an open-circuit characteristic to the first radio frequency signal. The second isolation circuit presents a short-circuit characteristic to the first radio frequency signal, and presents an open-circuit characteristic to the second radio frequency signal. The third isolation circuit presents a short-circuit characteristic to the first radio frequency signal, and presents an open-circuit characteristic to the second radio frequency signal. The fourth isolation circuit presents a short-circuit characteristic to the second radio frequency signal, and presents an open-circuit characteristic to the first radio frequency signal.

Example 2 of a connection relationship: A first end of the connecting microstrip line is coupled to a combining port of the first inter-frequency power division subcircuit, and a second end of the connecting microstrip line is coupled to a combining port of the second inter-frequency power division subcircuit. The output port of the first auxiliary amplification circuit is coupled to the combining port of the first inter-frequency power division subcircuit. The output port of the first main amplification circuit and a first division port of the first inter-frequency power division subcircuit are coupled to form the first output port of the first inter-frequency power division circuit. The output port of the second auxiliary amplification circuit is coupled to the combining port of the second inter-frequency power division subcircuit. The output port of the second main amplification circuit and a first division port of the second inter-frequency power division subcircuit are coupled to form the second output port of the first inter-frequency power division circuit.

For example, the first inter-frequency power division circuit includes a fifth microstrip line, a sixth microstrip line, and a fifth isolation circuit. The second inter-frequency power division circuit includes a seventh microstrip line, an eighth microstrip line, and a sixth isolation circuit. A first end of the fifth microstrip line is used as the combining port of the first inter-frequency power division subcircuit, and a second end of the fifth microstrip line is used as the first division port of the first inter-frequency power division subcircuit. The output port of the first main amplification circuit is coupled to the second end of the fifth microstrip line through the sixth microstrip line. A first end of the seventh microstrip line is used as the combining port of the second inter-frequency power division subcircuit, and a second end of the seventh microstrip line is used as the first division port of the second inter-frequency power division subcircuit. The output port of the second main amplification circuit is coupled to the second end of the seventh microstrip line through the eighth microstrip line. The fifth isolation circuit is coupled to the first division port of the first inter-frequency power division subcircuit. The sixth isolation circuit is coupled to the first division port of the second inter-frequency power division subcircuit. The fifth isolation circuit presents a short-circuit characteristic to the second radio frequency signal, and presents an open-circuit characteristic to the first radio frequency signal. The sixth isolation circuit presents a short-circuit characteristic to the first radio frequency signal, and presents an open-circuit characteristic to the second radio frequency signal.

Example 3 of a connection relationship: A first division port of the first inter-frequency power division subcircuit is coupled to the output port of the first main amplification circuit, a second division port of the first inter-frequency power division subcircuit is coupled to the output port of the second main amplification circuit, and a combining port of the first inter-frequency power division subcircuit and the output port of the first auxiliary amplification circuit are separately coupled to a first end of the connecting microstrip line. A combining port of the second inter-frequency power division subcircuit and the output port of the second auxiliary amplification circuit are separately coupled to a second end of the connecting microstrip line, a first division port of the second inter-frequency power division subcircuit is used as the first output port of the first inter-frequency power division circuit, and a second division port of the second inter-frequency power division subcircuit is used as the second output port of the first inter-frequency power division circuit.

For example, the first inter-frequency power division circuit includes a ninth microstrip line, a tenth microstrip line, a seventh isolation circuit, and an eighth isolation circuit. The second inter-frequency power division circuit includes an eleventh microstrip line, a twelfth microstrip line, a ninth isolation circuit, and a tenth isolation circuit. A first end of the ninth microstrip line is used as the first division port of the first inter-frequency power division subcircuit, a second end of the ninth microstrip line and a second end of the tenth microstrip line are coupled to form the combining port of the first inter-frequency power division subcircuit, and a first end of the tenth microstrip line is used as the second division port of the first inter-frequency power division subcircuit. A first end of the eleventh microstrip line is used as the first division port of the second inter-frequency power division subcircuit, a second end of the eleventh microstrip line and a second end of the twelfth microstrip line are coupled to form the combining port of the second inter-frequency power division subcircuit, and a first end of the twelfth microstrip line is used as the second division port of the second inter-frequency power division subcircuit. The seventh isolation circuit is coupled to the first division port of the first inter-frequency power division subcircuit. The eighth isolation circuit is coupled to the second division port of the first inter-frequency power division subcircuit. The ninth isolation circuit is coupled to the first division port of the second inter-frequency power division subcircuit. The tenth isolation circuit is coupled to the second division port of the second inter-frequency power division subcircuit. The seventh isolation circuit presents a short-circuit characteristic to the second radio frequency signal, and presents an open-circuit characteristic to the first radio frequency signal. The eighth isolation circuit presents a short-circuit characteristic to the first radio frequency signal, and presents an open-circuit characteristic to the second radio frequency signal. The ninth isolation circuit presents a short-circuit characteristic to the second radio frequency signal, and presents an open-circuit characteristic to the first radio frequency signal. The tenth isolation circuit presents a short-circuit characteristic to the first radio frequency signal, and presents an open-circuit characteristic to the second radio frequency signal.

For example, in the connection relationship 1, the connection relationship 2, and the connection relationship 3, the first inter-frequency power division circuit and/or the second inter-frequency power division circuit may also be microstrip inter-frequency power division circuits. The microstrip inter-frequency power division circuit includes a twenty-third microstrip line, a twenty-fourth microstrip line, a twenty-fifth microstrip line, a twenty-sixth microstrip line, a twenty-seventh microstrip line, a twenty-eighth microstrip line, and a twenty-ninth microstrip line. Electrical lengths of the twenty-fourth microstrip line and the twenty-fifth microstrip line are a quarter wavelength of the second radio frequency signal. Electrical lengths of the twenty-sixth microstrip line and the twenty-seventh microstrip line are a quarter wavelength of the first radio frequency signal. A first end of the twenty-third microstrip line is used as a first division port of the microstrip inter-frequency power division circuit, and a second end of the twenty-third microstrip line is separately coupled to a first end of the twenty-fourth microstrip line and a first end of the twenty-fifth microstrip line. A first end of the twenty-eighth microstrip line is used as a second division port of the microstrip inter-frequency power division circuit, and a second end of the twenty-eighth microstrip line is separately coupled to a first end of the twenty-seventh microstrip line and a first end of the twenty-sixth microstrip line. A second end of the twenty-fifth microstrip line and a second end of the twenty-sixth microstrip line are separately coupled to a first end of the twenty-ninth microstrip line, and a second end of the twenty-ninth microstrip line is used as a combining port of the microstrip inter-frequency power division circuit.

In some possible implementations, the first inter-frequency power division circuit may be an inter-frequency power division structure based on a microstrip line and a coupling bridge structure. In this case, the first inter-frequency power division circuit includes a coupling bridge, a thirteenth microstrip line, a fourteenth microstrip line, a fifteenth microstrip line, a sixteenth microstrip line, a seventeenth microstrip line, an eighteenth microstrip line, an eleventh isolation circuit, a twelfth isolation circuit, a thirteenth isolation circuit, and a fourteenth isolation circuit. A first end of the thirteenth microstrip line and a first end of the fifteenth microstrip line are coupled to the eleventh isolation circuit and then coupled to the output port of the first main amplification circuit, and a second end of the thirteenth microstrip line is separately coupled to the output port of the first auxiliary amplification circuit and a first port of the coupling bridge. A first end of the fourteenth microstrip line and a second end of the fifteenth microstrip line are coupled to the twelfth isolation circuit and then used as the second output port of the first inter-frequency power division circuit, and a second end of the fourteenth microstrip line is coupled to a second port of the coupling bridge. A first end of the sixteenth microstrip line is separately coupled to the output port of the second auxiliary amplification circuit and a third port of the coupling bridge, and a second end of the sixteenth microstrip line and a first end of the eighteenth microstrip line are coupled to the thirteenth isolation circuit and then coupled to the output port of the second main amplification circuit. A first end of the seventeenth microstrip line is coupled to a fourth port of the coupling bridge, and a second end of the seventeenth microstrip line and a second end of the eighteenth microstrip line are coupled to the fourteenth isolation circuit and then used as the first output port of the first inter-frequency power division circuit. The eleventh isolation circuit presents a short-circuit characteristic to the second radio frequency signal, and presents an open-circuit characteristic to the first radio frequency signal. The twelfth isolation circuit presents a short-circuit characteristic to the first radio frequency signal, and presents an open-circuit characteristic to the second radio frequency signal. The thirteenth isolation circuit presents a short-circuit characteristic to the first radio frequency signal, and presents an open-circuit characteristic to the second radio frequency signal. The fourteenth isolation circuit presents a short-circuit characteristic to the second radio frequency signal, and presents an open-circuit characteristic to the first radio frequency signal. The first port and the third port of the coupling bridge are isolated ports of each other, and the first port and the second port of the coupling bridge are through ports of each other.

For example, the coupling bridge includes a nineteenth microstrip line, a twentieth microstrip line, a twenty-first microstrip line, and a twenty-second microstrip line. A first end of the nineteenth microstrip line and a first end of the twentieth microstrip line are coupled to form the first port of the coupling bridge. A second end of the nineteenth microstrip line and a first end of the twenty-first microstrip line are coupled to form the second port of the coupling bridge. A second end of the twentieth microstrip line and a first end of the twenty-second microstrip line are coupled to form the third port of the coupling bridge. A second end of the twenty-first microstrip line and a second end of the twenty-second microstrip line are coupled to form the fourth port of the coupling bridge.

In this embodiment of this application, based on a case in which a wideband signal is converted into a narrowband signal by inter-frequency power division, a design requirement on an isolation circuit of an output port is lowered, and a narrowband isolator may be used as an isolation circuit, to avoid an insertion loss and a design difficulty caused by a wideband isolator.

In a possible implementation, the multi-way power amplification architecture further includes a second inter-frequency power division circuit. The first output port of the first inter-frequency power division circuit is coupled to a first division port of the second inter-frequency power division circuit, and the second output port of the first inter-frequency power division circuit is coupled to a second division port of the second inter-frequency power division circuit. A combining port of the second inter-frequency power division circuit is configured to output any one of the following signals: the first radio frequency combined signal, the second radio frequency combined signal, and a combined signal of the first radio frequency combined signal and the second radio frequency combined signal. In this embodiment of this application, the multi-way power amplification architecture may form a dual-frequency dual-output structure based on the first inter-frequency power division circuit, or may form a dual-frequency single-output architecture based on the second inter-frequency power division circuit.

For example, the second inter-frequency power division circuit may be a conventional inter-frequency power divider.

For example, the second inter-frequency power division circuit may also be a microstrip structure in the foregoing embodiment related to the first inter-frequency power division circuit and the second inter-frequency power division circuit, for example, a structure recorded in the foregoing microstrip inter-frequency power division circuit.

In a possible implementation, at least one of the first main amplification circuit, the second main amplification circuit, the first auxiliary amplification circuit, and the second auxiliary amplification circuit is a power combining circuit, and the power combining circuit includes a plurality of amplification branch circuits.

For example, the power combining circuit includes at least one of the following: a Doherty circuit, an inverse Doherty circuit, an asymmetric Doherty circuit, an LMBA circuit, an SLMBA circuit, a balun voltage-type combining circuit, a Chireix amplification circuit, and an outphasing modulation and amplification circuit.

In this embodiment of this application, when a wideband signal is converted into a narrowband signal by inter-frequency power division, circuit design difficulty is reduced, to facilitate architecture expansion design, so as to obtain a larger backoff amount and the like.

In a possible implementation, the multi-way power amplification architecture further includes a division circuit and a first coupler. The division circuit is configured to: input the first radio frequency signal and the second radio frequency signal, separately output the first radio frequency signal to an input port of the first main amplification circuit and a first port of the first coupler, and separately output the second radio frequency signal to an input port of the second main amplification circuit and a third port of the first coupler. A second port of the first coupler and a fourth port of the first coupler are configured to separately output the radio frequency frequency-combined signal to an input port of the first auxiliary amplification circuit and an input port of the second auxiliary amplification circuit.

For example, the division circuit includes a first power divider and a second power divider. A combining port of the first power divider is configured to input the first radio frequency signal, and a first division port and a second division port of the first power divider are separately configured to output one first radio frequency signal. A combining port of the second power divider is configured to input the second radio frequency signal. A first division port and a second division port of the second power divider are separately configured to output one second radio frequency signal.

For example, the division circuit includes a first inter-frequency power divider and a second inter-frequency power divider. A combining port of the first inter-frequency power divider is configured to input the first radio frequency signal and the second radio frequency signal. A first division port of the first inter-frequency power divider outputs one first radio frequency signal. A second division port of the first inter-frequency power divider is configured to output one second radio frequency signal. A combining port of the second inter-frequency power divider is configured to input the first radio frequency signal and the second radio frequency signal. A first division port of the second inter-frequency power divider outputs one first radio frequency signal. A second division port of the second inter-frequency power divider is configured to output one second radio frequency signal.

In some examples, the first inter-frequency power divider and/or the second inter-frequency power divider may be an inter-frequency power division circuit based on a microstrip line structure, or may be an inter-frequency power division circuit in another circuit structure.

For example, the division circuit includes a third inter-frequency power divider, a third power divider, and a fourth power divider. A first division port and a second division port of the third inter-frequency power divider are respectively coupled to a combining port of the third power divider and a combining port of the fourth power divider. A combining port of the third inter-frequency power divider is configured to input the first radio frequency signal and the second radio frequency signal. The first division port of the third inter-frequency power divider is configured to output the first radio frequency signal. The second division port of the third inter-frequency power divider is configured to output the second radio frequency signal. A first division port and a second division port of the third power divider are separately configured to output one first radio frequency signal. A first division port and a second division port of the fourth power divider are separately configured to output one second radio frequency signal.

In some examples, the third inter-frequency power divider may be an inter-frequency power division circuit based on a microstrip line structure, or may be an inter-frequency power division circuit in another circuit structure.

In this embodiment of this application, a radio frequency signal of a corresponding band may be output to the first main amplification circuit, the second main amplification circuit, the first auxiliary amplification circuit, and the second auxiliary amplification circuit in different manners by combining the division circuit and the first coupler.

In a possible implementation, the first radio frequency signal and/or the second radio frequency signal includes a radio frequency signal of at least one subband. In this embodiment of this application, one radio frequency signal with a large bandwidth may be divided into a plurality of first radio frequency signals and second radio frequency signals with small bandwidths. In a smaller relative bandwidth, convergence of an impedance design is more friendly, and efficiency of each amplification branch can be further improved, to improve backoff efficiency and full-load efficiency of the multi-way power amplification architecture. In addition, a conventional wideband main amplification circuit is divided into a plurality of radio frequency signals with small bandwidths, so that a difficulty in VBW design in a concurrency scenario can be avoided, and concurrency performance is not degraded.

In a possible implementation, a minimum operating power point of the first main amplification circuit is less than a minimum operating power point of the first auxiliary amplification circuit and a minimum operating power point of the second auxiliary amplification circuit, a minimum operating power point of the second main amplification circuit is less than the minimum operating power point of the first auxiliary amplification circuit and the minimum operating power point of the second auxiliary amplification circuit, and the minimum operating power point of the first auxiliary amplification circuit is less than, equal to, or greater than the minimum operating power point of the second auxiliary amplification circuit. In this embodiment of this application, a turn-on sequence between auxiliary amplification circuits is not limited, and the turn-on sequence may be adjusted according to an actual application.

In a possible implementation, the multi-way power amplification architecture further includes a drive circuit or a control circuit, and the minimum operating power points of the first main amplification circuit, the second main amplification circuit, the first auxiliary amplification circuit, and the second auxiliary amplification circuit are controlled based on the drive circuit or the control circuit. In this embodiment of this application, a turn-on sequence of the first auxiliary amplification circuit and the second auxiliary amplification circuit in a same architecture may alternatively be reversed (for example, in an architecture, for a radio frequency signal of the first band, the first auxiliary amplification circuit may be turned on before the second auxiliary amplification circuit, but for a radio frequency signal of the second band, the second auxiliary amplification circuit may be turned on before the first auxiliary amplification circuit). Therefore, the drive circuit or the control circuit in a digital domain may be configured to control the minimum operating power points of the first main amplification circuit, the second main amplification circuit, the first auxiliary amplification circuit, and the second auxiliary amplification circuit, to control the turn-on sequence.

In a possible implementation, at least one of the plurality of microstrip lines is a microstrip line in a three-dimensional stacked structure. For example, the microstrip line may be a suspended microstrip line. In this embodiment of this application, performance of a microstrip line in the three-dimensional stacked structure is consistent with that of a common microstrip line, but an area of the microstrip line is far less than that of the common microstrip line. The microstrip line in the three-dimensional stacked structure can reduce more area overheads of the multi-way power amplification architecture.

According to a second aspect, an embodiment of this application further provides a radio frequency generation device. The radio frequency generation device includes a radio frequency generation circuit and the multi-way power amplification architecture described in the first aspect. The radio frequency generation circuit is configured to output a radio frequency signal to the multi-way power amplification architecture. A power amplifier is configured to perform power combination and amplification based on the radio frequency signal.

According to a third aspect, an embodiment of this application further provides a communication system. The communication system includes a baseband processing device and the radio frequency generation device described in the second aspect. The baseband processing device is configured to output a baseband signal to the radio frequency generation device. The radio frequency generation device is configured to obtain a radio frequency signal based on the baseband signal, and perform power-combining amplification on the radio frequency signal.

For technical principles and beneficial effects of the second aspect and the third aspect, refer to related descriptions of the first aspect. Details are not described herein again.

### BRIEF DESCRIPTION OF DRAWINGS

FIG. 1 is a diagram of a structure of a power amplifier;
FIG. 2 is a diagram of a structure of a communication system according to an embodiment of this application;
FIG. 3 is a diagram of a structure of a radio frequency generation device according to an embodiment of this application;
FIG. 4 is a diagram of a structure of a first multi-way power amplification architecture according to an embodiment of this application;
FIG. 5(a) and FIG. 5(b) are diagrams of a structure of another first multi-way power amplification architecture according to an embodiment of this application;
FIG. 6 is a diagram of a structure of a second multi-way power amplification architecture according to an embodiment of this application;
FIG. 7 is a diagram of a structure of a third multi-way power amplification architecture according to an embodiment of this application;
FIG. 8 is a diagram of a structure of a fourth multi-way power amplification architecture according to an embodiment of this application;
FIG. 9 is a diagram of a structure of a fifth multi-way power amplification architecture according to an embodiment of this application;
FIG. 10 is a diagram 1 of a structure of a sixth multi-way power amplification architecture according to an embodiment of this application;
FIG. 11 is a diagram 2 of a structure of another sixth multi-way power amplification architecture according to an embodiment of this application;
FIG. 12 is a diagram 3 of a structure of still another sixth multi-way power amplification architecture according to an embodiment of this application;
FIG. 13(a) and FIG. 13(b) are diagrams of a frequency-division equivalent structure of the sixth multi-way power amplification architecture recorded in FIG. 12 according to an embodiment of this application;
FIG. 14 is a diagram of efficiency-power backoff of the sixth multi-way power amplification architecture recorded in FIG. 11 and FIG. 12 in a first band according to an embodiment of this application;
FIG. 15 is a diagram of a voltage-power backoff response relationship of the sixth multi-way power amplification architecture recorded in FIG. 11 and FIG. 12 in a first band according to an embodiment of this application;
FIG. 16 is a diagram of a phase-power backoff response relationship of the sixth multi-way power amplification architecture recorded in FIG. 11 and FIG. 12 in a first band according to an embodiment of this application;
FIG. 17 is a diagram of efficiency-power backoff of the sixth multi-way power amplification architecture recorded in FIG. 11 and FIG. 12 in a second band according to an embodiment of this application;
FIG. 18 is a diagram of a voltage-power backoff response relationship of the sixth multi-way power amplification architecture recorded in FIG. 11 and FIG. 12 in a second band according to an embodiment of this application;
FIG. 19 is a diagram of a phase-power backoff response relationship of the sixth multi-way power amplification architecture recorded in FIG. 11 and FIG. 12 in a second band according to an embodiment of this application;
FIG. 20 is a diagram 4 of a structure of still another sixth multi-way power amplification architecture according to an embodiment of this application;
FIG. 21 is a diagram 5 of a structure of still another sixth multi-way power amplification architecture according to an embodiment of this application;
FIG. 22(a) and FIG. 22(b) are diagrams of a frequency-division equivalent structure of the sixth multi-way power amplification architecture recorded in FIG. 21 according to an embodiment of this application;
FIG. 23 is a diagram of efficiency-power backoff of the sixth multi-way power amplification architecture recorded in FIG. 20 and FIG. 21 in a first band according to an embodiment of this application;
FIG. 24 is a diagram of a voltage-power backoff response change relationship of the sixth multi-way power amplification architecture recorded in FIG. 20 and FIG. 21 in a first band according to an embodiment of this application;
FIG. 25 is a diagram of a phase-power backoff response change relationship of the sixth multi-way power amplification architecture recorded in FIG. 20 and FIG. 21 in a first band according to an embodiment of this application;
FIG. 26 is a diagram of efficiency-power backoff of the sixth multi-way power amplification architecture recorded in FIG. 20 and FIG. 21 in a second band according to an embodiment of this application;
FIG. 27 is a diagram of a voltage-power backoff response change relationship of the sixth multi-way power amplification architecture recorded in FIG. 20 and FIG. 21 in a second band according to an embodiment of this application;
FIG. 28 is a diagram of a phase-power backoff response change relationship of the sixth multi-way power amplification architecture recorded in FIG. 20 and FIG. 21 in a second band according to an embodiment of this application;
FIG. 29 is a diagram 6 of a structure of still another sixth multi-way power amplification architecture according to an embodiment of this application;
FIG. 30 is a diagram 7 of a structure of still another sixth multi-way power amplification architecture according to an embodiment of this application;
FIG. 31 is a diagram of efficiency-power backoff of the sixth multi-way power amplification architecture recorded in FIG. 29 and FIG. 30 in a first band according to an embodiment of this application;
FIG. 32 is a diagram of a voltage-power backoff response change relationship of the sixth multi-way power amplification architecture recorded in FIG. 29 and FIG. 30 in a first band according to an embodiment of this application;
FIG. 33 is a diagram of a phase-power backoff response change relationship of the sixth multi-way power amplification architecture recorded in FIG. 29 and FIG. 30 in a first band according to an embodiment of this application;
FIG. 34 is a diagram of efficiency-power backoff of the sixth multi-way power amplification architecture recorded in FIG. 29 and FIG. 30 in a second band according to an embodiment of this application;
FIG. 35 is a diagram of a voltage-power backoff response change relationship of the sixth multi-way power amplification architecture recorded in FIG. 29 and FIG. 30 in a second band according to an embodiment of this application;
FIG. 36 is a diagram of a phase-power backoff response change relationship of the sixth multi-way power amplification architecture recorded in FIG. 29 and FIG. 30 in a second band according to an embodiment of this application;
FIG. 37 is a diagram of a structure of a microstrip inter-frequency power division circuit according to an embodiment of this application;
FIG. 38 is a diagram 8 of a structure of still another sixth multi-way power amplification architecture according to an embodiment of this application;
FIG. 39 is a diagram 9 of a structure of still another sixth multi-way power amplification architecture according to an embodiment of this application;
FIG. 40(a) and FIG. 40(b) are diagrams of a frequency-division equivalent structure of the sixth multi-way power amplification architecture recorded in FIG. 39 according to an embodiment of this application;
FIG. 41 is a diagram of efficiency-power backoff of the sixth multi-way power amplification architecture recorded in FIG. 38 and FIG. 39 in a first band according to an embodiment of this application;
FIG. 42 is a diagram of a voltage-power backoff response change relationship of the sixth multi-way power amplification architecture recorded in FIG. 38 and FIG. 39 in a first band according to an embodiment of this application;
FIG. 43 is a diagram of a phase-power backoff response change relationship of the sixth multi-way power amplification architecture recorded in FIG. 38 and FIG. 39 in a first band according to an embodiment of this application;
FIG. 44 is a diagram of efficiency-power backoff of the sixth multi-way power amplification architecture recorded in FIG. 38 and FIG. 39 in a second band according to an embodiment of this application;
FIG. 45 is a diagram of a voltage-power backoff response change relationship of the sixth multi-way power amplification architecture recorded in FIG. 38 and FIG. 39 in a second band according to an embodiment of this application;
FIG. 46 is a diagram of a phase-power backoff response change relationship of the sixth multi-way power amplification architecture recorded in FIG. 38 and FIG. 39 in a second band according to an embodiment of this application;
FIG. 47 is a diagram 10 of a structure of still another sixth multi-way power amplification architecture according to an embodiment of this application;
FIG. 48 is a diagram 11 of a structure of still another sixth multi-way power amplification architecture according to an embodiment of this application;
FIG. 49 is a diagram 12 of a structure of still another sixth multi-way power amplification architecture according to an embodiment of this application;
FIG. 50 is a diagram 13 of a structure of still another sixth multi-way power amplification architecture according to an embodiment of this application; and
FIG. 51 is a diagram 14 of a structure of still another sixth multi-way power amplification architecture according to an embodiment of this application.

### DESCRIPTION OF EMBODIMENTS

It should be noted that terms such as "first" and "second" in embodiments of this application are merely used to distinguish between features of a same type, and cannot be understood as an indication of relative importance, a quantity, a sequence, or the like.

The term such as "example" or "for example" in embodiments of this application is used to represent giving an example, an illustration, or a description. Any embodiment or design scheme described as an "example" or "for example" in this application should not be explained as being more preferred or having more advantages than another embodiment or design scheme. To be precise, use of the word such as "example" or "for example" is intended to present a related concept in a specific manner.

The terms "coupling" and "connection" in embodiments of this application should be understood in a broad sense. For example, the terms may be a physical direct connection, or may be an indirect connection implemented through an electronic device, for example, a connection implemented through a resistor, an inductor, a capacitor, a microstrip line, an impedance transformation line, an impedance inversion line, a filter, or another electronic device.

First, some basic concepts in embodiments of this application are explained and described.

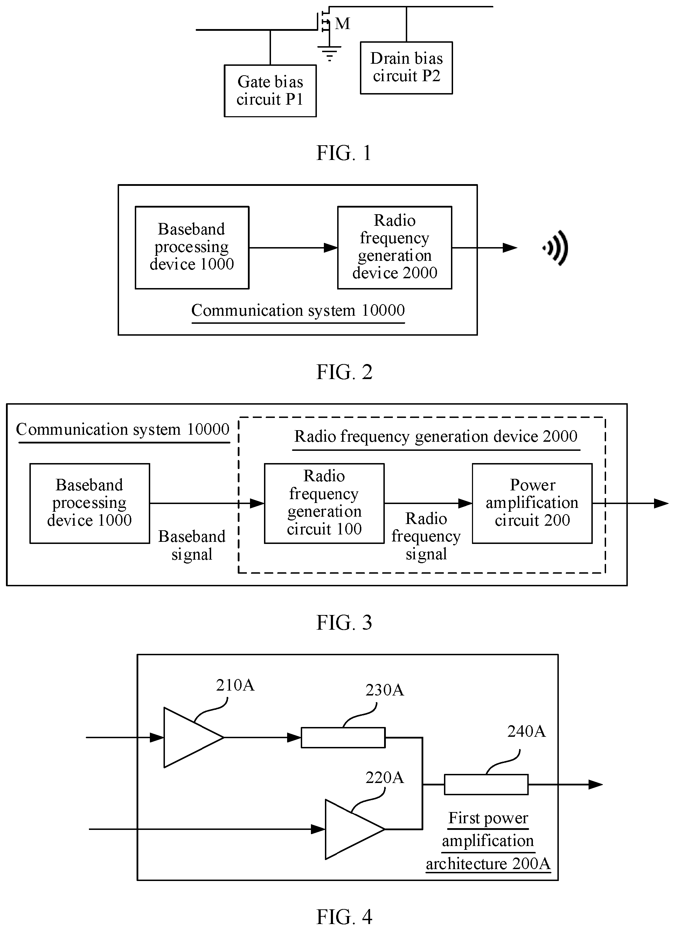

Power amplifier: The power amplifier may be classified into a power transistor-type power amplifier and a switching-type power amplifier. The power transistor-type power amplifier may be further classified into a class-A power amplifier, a class-B power amplifier, a class-AB power amplifier, and a class-C power amplifier. The class-A power amplifier, the class-B power amplifier, and the class-AB power amplifier are linear power amplifiers. The class-C power amplifier is a non-linear power amplifier. In embodiments of this application, for class-C power amplifiers, according to different minimum turn-on power points of the class-C power amplifiers, degrees of class-C may be further classified, for example, classified into shallow class-C, class-C, and deep class-C. In embodiments of this application, such classification only indicates that minimum turn-on power points of a plurality of class-C power amplifiers are also different based on a difference between gate voltage configurations of power transistors. The class-A power amplifier exhibits highest linearity and is suitable for power amplification of a small direct current signal. The class-B power amplifier operates in a half-cycle manner. A single-ended class-B power amplifier may produce significant non-linear distortion, and is seldom used for power amplification of a radio frequency signal. Generally, a push-pull structure is formed based on two class-B power amplifiers to produce a positive half cycle and a negative half cycle, and is used for power amplification of an audio signal. The class-AB power amplifier is a combination of the class-A power amplifier and the class-B power amplifier. Efficiency and linearity of the class-AB power amplifier are between efficiency and linearity of the class-A power amplifier and efficiency and linearity of the class-B power amplifier, and the class-AB power amplifier is widely used for power amplification of a radio frequency signal. The class-C power amplifier is nonlinear and is often used in a multi-way power amplification structure for power combination. FIG. 1 shows a basic structure of a single power transistor-type power amplifier. In the figure, a gate bias circuit P1 is disposed at a gate of a power amplification transistor M, and a drain bias circuit P2 is disposed at a drain of the power amplification transistor M. The gate bias circuit P1 and the drain bias circuit P2 control bias states of terminals of the power amplification transistor M, so that the power amplification transistor M is in a power amplification state. The power amplification transistor M in the power amplification state may perform power amplification on an input signal.

Power backoff of a power amplifier: With development of wireless communication technologies, a modulation technology of a radio frequency signal is gradually complex, so that a peak-to-average power ratio (peak to average power ratio, PAPR) of an output radio frequency signal increases. A radio frequency signal input by the power amplifier is a modulated signal obtained by modulating data information to a carrier signal. A power backoff amount is related to a peak-to-average power ratio of the modulated signal.

Operating efficiency of a power amplifier: The operating efficiency of the power amplifier may be represented by the drain efficiency of the power transistor M, that is, a ratio of a drain direct current provided by a system to a radio frequency signal actually output by the power amplifier. The operating efficiency of the power amplifier decreases as the output power decreases.

An embodiment of this application provides a communication system. As shown in FIG. 2, the communication system 10000 includes a baseband processing device 1000 and a radio frequency generation device 2000. The baseband processing device 1000 is coupled to the radio frequency generation device 2000. The baseband processing device 1000 is configured to output a baseband signal to the radio frequency generation device 2000. The radio frequency generation device 2000 is configured to obtain a radio frequency signal based on the baseband signal, and perform power-combining amplification on the radio frequency signal.

As shown in FIG. 3, the radio frequency generation device 2000 includes a radio frequency generation circuit 100 and a multi-way power amplification architecture 200. An output port of the radio frequency generation circuit 100 is coupled to the multi-way power amplification architecture 200. The radio frequency generation circuit 100 is configured to output a radio frequency signal to the multi-way power amplification architecture 200, and the multi-way power amplification architecture 200 is configured to perform power-combining amplification based on the radio frequency signal.

For example, the radio frequency generation device 2000 may be a remote radio unit (remote radio unit, RRU) or an active antenna unit (active antenna unit, AAU). The baseband processing device 1000 may be a building baseband unit (building base band unit, BBU) or the like.

With development of wireless communication technologies, an amount of data information that needs to be carried on a radio frequency signal also increases rapidly. Consequently, a bandwidth requirement for a radio frequency signal increases. To ensure efficiency of a radio frequency signal of a high peak-to-average power ratio after power amplification, a power backoff amount needs to be increased as much as possible. However, a power amplifier is a most power-consuming device in a transmitting apparatus. In a case of a large power backoff amount, how to ensure that the power amplifier maintains high efficiency is a major challenge. In addition, in a design of the power amplifier, improving backoff efficiency and extending an operating bandwidth are conflicting design requirements, and both have design difficulties. Designing a high-power, large-bandwidth, large-backoff amount, and high-efficiency power amplifier has always been a challenge in the industry. Main difficulties are as follows: Difficulty 1. From a perspective of designing a high-efficiency power amplifier, improving backoff efficiency is in conflict with extending an operating bandwidth. In an architecture design of most power amplifiers, a bandwidth and efficiency need to be balanced, and optimal efficiency cannot be achieved. Difficulty 2: From a perspective of designing a high-power power amplifier, a power transistor of the power amplifier has a smaller matching impedance and a larger parasitic parameter impact, and this seriously affects design of a solution. Difficulty 3: From a perspective of designing a multi-frequency power amplifier with a large bandwidth, a video bandwidth (video bandwidth, VBW) is an important factor that affects wideband concurrency, and controlling a VBW of a wideband power amplifier is also a great design challenge. Difficulty 4: An output port of a power amplifier in a base station needs to be connected to an isolator to ensure that performance of the power amplifier is not affected by back-end impedance mismatch. Performance of an output isolator for high-power wideband power amplification greatly affects performance such as an output insertion loss and linearity.

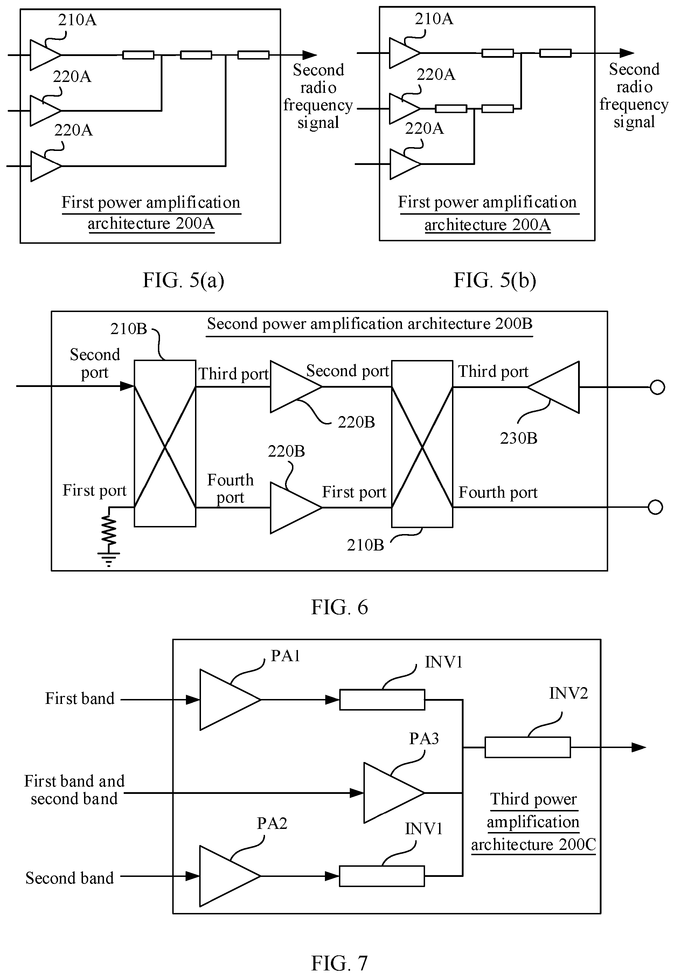

In some possible implementations, the multi-way power amplification architecture 200 may be a first power amplifier in a Doherty architecture. As shown in FIG. 4, the first multi-way power amplification architecture 200A includes a main amplification branch 210A, an auxiliary amplification branch 220A, an impedance inversion line 230A, and an impedance transformation line 240A. The main amplification branch 210A operates in a class B or class AB, and the auxiliary amplification branch 220A operates in a class C. When signal power of an input radio frequency signal is low, the main amplification branch 210A is turned on to operate. When signal power of the input radio frequency signal is high, the auxiliary amplification circuit 220A is turned on to operate. When the auxiliary amplification branch 220A is turned on, the impedance inversion line 230A performs impedance inversion on impedance of a combining point between the main amplification branch 210A and the auxiliary amplification branch 220A and impedance of the main amplification branch 210A, to implement power combination of radio frequency signals output by the two branches under load-pull, and impedance matching is performed based on the impedance transformation line 240A. By using the Doherty architecture shown in FIG. 4 and a variant architecture of the Doherty architecture, a good power backoff amount and operating efficiency can be maintained in single-frequency or dual-frequency signal amplification. For a conventional two-way Doherty power amplifier, increasing a power ratio of an auxiliary power amplifier and a main power amplifier may increase a backoff amount to some extent, but an efficiency dip between a backoff power point and a saturation power point is not conducive to overall efficiency of a modulated signal. Therefore, the two-way Doherty architecture shown in FIG. 4 may be extended to a three-way Doherty architecture. FIG. 5(a) and FIG. 5(b) show two different forms of Doherty architectures. The three-way Doherty architecture include two auxiliary amplification branches 220A. One auxiliary amplification branch 220A operates in a light class C, and the other auxiliary amplification branch 220A operates in a deep class C. That is, a minimum operating power point of the auxiliary amplification branch 220A of the light class C is less than a minimum operating power point of the auxiliary amplification branch 220A of the deep class C. The three-way Doherty architecture can fill the efficiency dip while increasing the backoff amount. However, in a conventional three-way Doherty architecture shown in FIG. 5(a), the main amplification branch 210A has only one impedance pulling process, and a load-pull ratio (load-pull ratio, LPR) of the main amplification branch 210A is small. However, in an improved three-way Doherty architecture shown in FIG. 5(b), the main amplification branch 210A may implement load-pull twice, to implement a large LPR. Because load-pull is performed on the main amplification branch 210A twice, a power backoff range of the main amplification branch 210A is also large. However, to increase a backoff amount in the architectures shown in FIG. 4 and FIG. 5(a) and FIG. 5(b), a quantity of impedance inversion lines 230A and a quantity of auxiliary amplification branches 220A need to be increased. This increases device costs and device areas of the first multi-way power amplification architecture 100A. In addition, when the quantity of amplification branches 220A reaches a specific quantity, an amplification gain coefficient of the first multi-way power amplification architecture 100A decreases. In addition, the impedance inversion line 230A has a specific frequency response, and causes a limitation on a bandwidth, and makes it extremely difficult for an engineer to perform a wideband design in the first multi-way power amplification architecture 100A. For example, in the two three-way Doherty architectures shown in FIG. 5(a) and FIG. 5(b), as a quantity of branches increases, a quantity of impedance inversion lines 230A also increases. This greatly limits an operating bandwidth. Therefore, how to improve an operating bandwidth and power amplification performance of the three-way Doherty architecture and a power amplification architecture with more than three ways is a major challenge.

In some possible implementations, the multi-way power amplification architecture 200 may be a second power amplifier based on a load modulated balanced amplifier (load modulated balanced amplifier, LMBA) architecture or a sequential load modulated balanced amplifier (sequential load modulated balanced amplifier, SLMBA) architecture. As shown in FIG. 6, a second multi-way power amplification architecture 200B may include two balanced couplers 210B, two balanced amplification circuits 220B, and a control amplification circuit 230B. A third port and a fourth port of a preceding balanced coupler 210B are respectively coupled to input ports of the two balanced amplification circuits 220B, and are coupled to a first port and a second port of a subsequent balanced coupler 210B through output ports of the two balanced amplification circuits 220B. An output port of the control amplification circuit 230B is coupled to a third port of the subsequent balanced coupler 210B. A fourth port of the subsequent balanced coupler 210B is used as an output port of the second multi-way power amplification architecture 200B. In some examples, the two balanced amplification circuits 220B are main amplifiers operating in a class AB, and the control amplification circuit 230B is an auxiliary amplifier operating in a class C. In this case, the second multi-way power amplification architecture 200B is an LMBA-based power amplifier. In some examples, the two balanced amplification circuits 220B are auxiliary amplifiers operating in the class C, and the control amplification circuit 230B is a main amplifier operating in the class AB. In this case, the second multi-way power amplification architecture 200B is an SLMBA-based power amplifier. In the embodiment shown in FIG. 6, the third port and the fourth port of the preceding balanced coupler 210B output two radio frequency signals with a phase difference of 90°. The two radio frequency signals are output to the subsequent balanced coupler 210B after being amplified by the balanced amplification circuit 220B. A radio frequency signal output by the control amplification circuit 230B coupled to the subsequent balanced coupler 210B may control the subsequent balanced coupler 210B to perform amplitude and phase modulation on three radio frequency signals, to achieve optimal load-pull effect in each band, and a combined radio frequency signal is output from the fourth port of the subsequent balanced coupler 210B. However, in the solution design shown in FIG. 6, first, to satisfy a current base station requirement, a power ratio solution in which an operating power of an auxiliary amplifier is higher than an operating power of a main amplifier is usually used, and a problem of an efficiency dip caused by this cannot be ignored. Second, VBW control is difficult in a wideband scenario. In a concurrent scenario, degradation in power, efficiency, and linear performance still exists. Third, a balanced coupler is used as an output power combination unit in the architecture. In a current high-power power amplification design, a power handling capability of the balanced coupler is a great challenge. Fourth, in a single-output power amplification solution, it is difficult to achieve good performance of the wideband isolator connected to an output.

In some possible implementations, the multi-way power amplification architecture 200 may be a third multi-way power amplification architecture based on a dual-frequency single-output Doherty architecture with a shared auxiliary path. As shown in FIG. 7, the third multi-way power amplification architecture 200C includes a first single-frequency main amplification circuit PA1, a second single-frequency main amplification circuit PA2, a dual-frequency shared auxiliary amplification circuit PA3, a first impedance inversion network INV1, and a second impedance transformation network INV2. The first single-frequency main amplification circuit PA1 operates in a class AB, and is configured to perform power amplification on a radio frequency signal of a first band. The second single-frequency main amplification circuit PA2 operates in the class AB, and is configured to perform power amplification on a radio frequency signal of a second band. The dual-frequency shared auxiliary amplification circuit PA3 operates in a class C, and is configured to perform power amplification on radio frequency signals of the first band and the second band. An output port of the first single-frequency main amplification circuit PA1 and an output port of the second single-frequency main amplification circuit PA2 are separately coupled to an output port of the dual-frequency shared auxiliary amplification circuit PA3 through one first impedance inversion network INV1 and then coupled to the second impedance transformation network INV2. The first single-frequency main amplification circuit PA1 and the dual-frequency shared auxiliary amplification circuit PA3 may form a Doherty architecture related to the first band through a corresponding first impedance inversion network INV1 and a corresponding second impedance transformation network INV2. The second single-frequency main amplification circuit PA2 and the dual-frequency shared auxiliary amplification circuit PA3 may form a Doherty architecture related to the second band through a corresponding first impedance inversion network INV1 and a corresponding second impedance transformation network INV2. In this embodiment of this application, the third multi-way power amplification architecture 200C shown in FIG. 7 can avoid a problem that a main circuit enters a saturation region in advance due to interaction of concurrent signals in a concurrent scenario, and resolve a problem of degradation in saturation power, efficiency, and linear performance in the concurrent scenario. However, in a design of high-power wideband power amplifier, an open-circuit characteristic of an auxiliary amplification circuit greatly increases a design difficulty. In addition, an output of the wideband single-output solution needs to be connected to a wideband isolator, and a current design of the wideband isolator is difficult to achieve good performance.

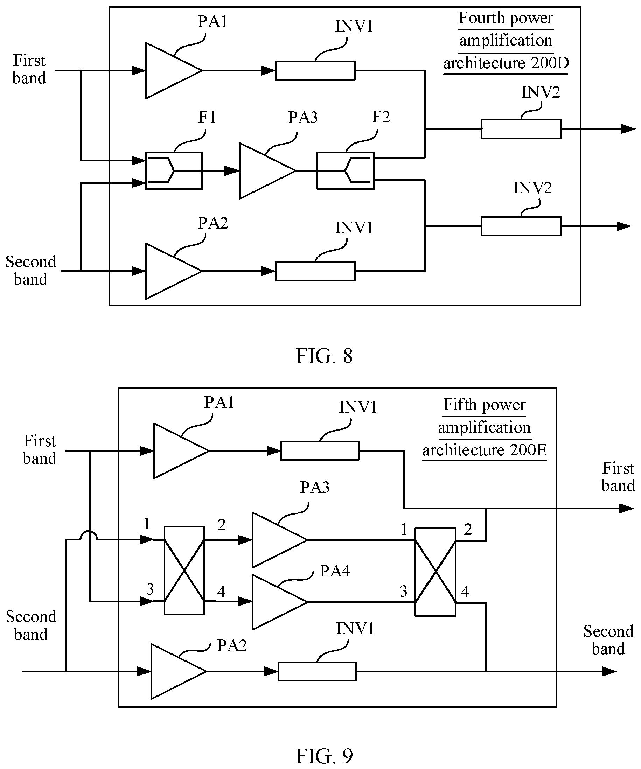

In some possible implementations, the multi-way power amplification architecture 200 may be a fourth multi-way power amplification architecture based on a dual-frequency dual-output Doherty architecture with a shared auxiliary path. As shown in FIG. 8, the fourth multi-way power amplification architecture 200D includes a first single-frequency main amplification circuit PA1, a second single-frequency main amplification circuit PA2, a dual-frequency shared auxiliary amplification circuit PA3, two first impedance inversion networks INV1, two second impedance transformation networks INV2, a preceding inter-frequency power divider F1, and a subsequent inter-frequency power divider F2. The first single-frequency main amplification circuit PA1 and the second single-frequency main amplification circuit PA2 separately operate in a class AB, and the dual-frequency shared auxiliary amplification circuit PA3 operates in a class C. Two division ports of the preceding inter-frequency power divider F1 respectively input radio frequency signals of a first band and a second band, and a combining port of the preceding inter-frequency power divider F1 outputs the radio frequency signals of the first band and the second band to an input port of the dual-frequency shared auxiliary amplification circuit PA3. An output port of the dual-frequency shared auxiliary amplification circuit PA3 outputs amplified radio frequency signals of the first band and the second band to a combining port of the subsequent inter-frequency power divider F2. An output port of the first single-frequency main amplification circuit PA1 and an output port of the second single-frequency main amplification circuit PA2 each are coupled to one first impedance inversion network INV1, and are coupled to two division ports of the subsequent inter-frequency power divider F2 through the corresponding first impedance inversion networks INV1. One division port of the subsequent inter-frequency power divider F2 outputs the radio frequency signal of the first band to the first impedance inversion network INV1 corresponding to the first single-frequency main amplification circuit PA1, to form a Doherty architecture with the corresponding second impedance transformation network INV2 for power combination of radio frequency signals of the first band. The other division port of the subsequent inter-frequency power divider F2 outputs the radio frequency signal of the second band to the first impedance inversion network INV1 corresponding to the second single-frequency main amplification circuit PA2, to form a Doherty architecture with the corresponding second impedance transformation network INV2 for power combination of radio frequency signals of the second band. In this embodiment of this application, in the architecture shown in FIG. 8, an inter-frequency power divider is used to implement dual output in different bands of the auxiliary amplification circuit. In a wideband dual-output solution, the output signal of the power amplifier in the communication system may be connected to the antenna through two narrowband isolators, to reduce impact of the wideband isolator on link performance. However, in this architecture, the inter-frequency power divider not only needs to satisfy an inter-frequency power division characteristic, but also needs to participate in load-pull of radio frequency signals of two bands, and this increases design difficulty. In addition, an insertion loss further causes performance degradation of the solution, further increasing design difficulty. In addition, the open-circuit characteristic of the auxiliary amplifier circuit is still a design difficulty. In addition, in this architecture, each band can only be equivalent to a two-way Doherty architecture, there are only two power saturation points, and a power backoff amount is small.

In some possible implementations, the multi-way power amplification architecture 200 may be a fifth multi-way power amplification architecture based on a dual-frequency dual-output Doherty architecture implemented by a bridge. As shown in FIG. 9, the fifth multi-way power amplification architecture 200E includes a first single-frequency main amplification circuit PA1, a second single-frequency main amplification circuit PA2, a first dual-frequency shared auxiliary amplification circuit PA3, a second dual-frequency shared auxiliary amplification circuit PA4, two first impedance inversion networks INV1, a first bridge B1, and a second bridge B2. A first port and a third port of the first bridge B1 are used to input a radio frequency signal of a first band and a radio frequency signal of a second band. A second port and a fourth port of the first bridge B1 respectively output radio frequency signals obtained by frequency combination of the first band and the second band to an input port of the first dual-frequency shared auxiliary amplification circuit PA3 and an input port of the second dual-frequency shared auxiliary amplification circuit PA4. An output port of the first dual-frequency shared auxiliary amplification circuit PA3 and an output port of the second dual-frequency shared auxiliary amplification circuit PA4 are respectively coupled to a first port and a third port of the second bridge B2. An input port of the first single-frequency main amplification circuit PA1 is used to input a radio frequency signal of the first band. An output port of the first single-frequency main amplification circuit PA1 is coupled to a second port of the second bridge B2 through a corresponding first impedance inversion network, to perform power combination of the first band. An input port of the second single-frequency main amplification circuit PA2 is used to input a radio frequency signal of the second band. An output port of the second single-frequency main amplification circuit PA2 is coupled to a fourth port of the second bridge B2 through a corresponding first impedance inversion network INV1, to perform power combination of a radio frequency signal of the second band. In the fifth multi-way power amplification architecture 200E shown in FIG. 9, an inter-frequency power division function may be implemented by using a phase characteristic of the second bridge B2 in combination with an isolation circuit, so that radio frequency signals of different bands are output from the second port and the fourth port of the second bridge B2. The radio frequency signals of different bands can be further combined with the first single-frequency main amplification circuit PA1 or the second single-frequency main amplification circuit PA2, to obtain a power-combined radio frequency signal of the first band or a power-combined radio frequency signal of the second band. However, in the implementation shown in FIG. 9, an insertion loss of the bridge is large, and this affects overall performance of a power amplifier. In addition, a size of the bridge is large, and this is not conducive to miniaturization and integration of a power amplification device. In addition, characteristic impedance of the bridge is fixed, and the bridge can be designed only according to a specific characteristic impedance. This limits design freedom of a matching circuit of the power amplifier, and greatly increases design difficulty and application difficulty in a multi-way amplification architecture.

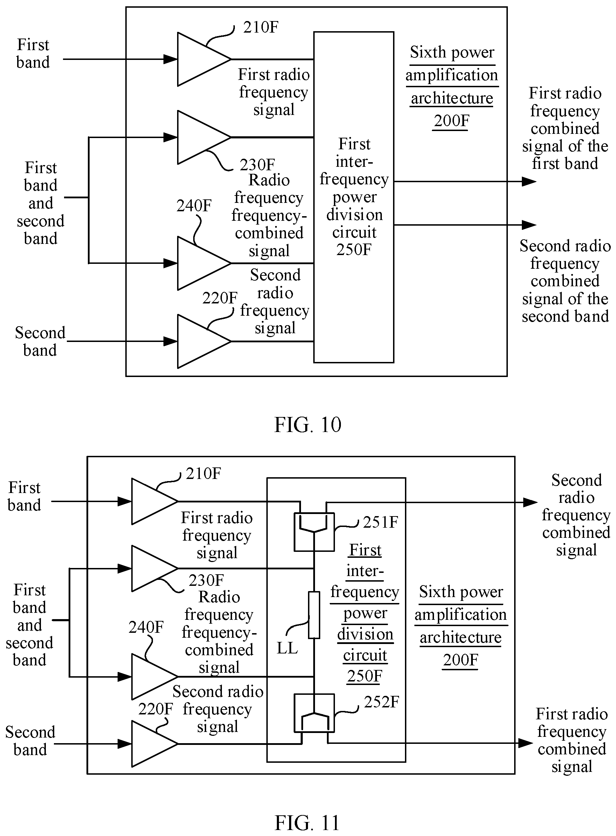

To reduce design difficulty of a power amplifier with a large backoff amount, high efficiency, and a large power bandwidth, in some possible implementations, as shown in FIG. 10, the sixth multi-way power amplification architecture 200F includes a first main amplification circuit 210F, a second main amplification circuit 220F, a first auxiliary amplification circuit 230F, a second auxiliary amplification circuit 240F, and a first inter-frequency power division circuit 250F. The first inter-frequency power division circuit 250F includes at least one microstrip line. An output port of the first main amplification circuit 210F, an output port of the second main amplification circuit 220F, an output port of the first auxiliary amplification circuit 230F, and an output port of the second auxiliary amplification circuit 240F are separately coupled to the first inter-frequency power division circuit 250F.

The output port of the first main amplification circuit 210F is used to output a first radio frequency signal. The output port of the second main amplification circuit 220F is used to output a second radio frequency signal. The output port of the first auxiliary amplification circuit 230F and the output port of the second auxiliary amplification circuit 240F are used to output a radio frequency frequency-combined signal, and the radio frequency frequency-combined signal includes the first radio frequency signal and/or the second radio frequency signal. A first output port of the first inter-frequency power division circuit 250F is used to implement power combination of the first radio frequency signals. A second output port of the first inter-frequency power division circuit 250F is used to implement power combination of the second radio frequency signals.

In the embodiment shown in FIG. 10 of this application, inter-frequency power division is not performed based on a bridge, but is performed based on the first inter-frequency power division circuit 250F having an inter-frequency power division function. The first inter-frequency power division circuit 250F is separately coupled to the first main amplification circuit 210F, the second main amplification circuit 220F, the first auxiliary amplification circuit 230F, and the second auxiliary amplification circuit 240F. The first main amplification circuit 210F may perform power amplification on a radio frequency signal of a first band, to obtain the first radio frequency signal, and the second main amplification circuit 220F may perform power amplification on a radio frequency signal of a second band, to obtain the second radio frequency signal. The first auxiliary amplification circuit 230F and the second auxiliary amplification circuit 240F may perform power amplification on the radio frequency signals of the first band and/or the second band, to separately obtain one radio frequency combined signal that may include the first radio frequency signal and/or the second radio frequency signal. The first inter-frequency power division circuit 250F may distinguish the first radio frequency signal and the second radio frequency signal based on the inter-frequency power division function, and implement power combination of the first radio frequency signals output by the first main amplification circuit 210F, the first auxiliary amplification circuit 230F, and the second auxiliary amplification circuit 240F, or may implement power combination of the second radio frequency signals output by the second main amplification circuit 220F, the first auxiliary amplification circuit 230F, and the second auxiliary amplification circuit 240F.

In some possible implementations, two inter-frequency power division subcircuits may be used in the first inter-frequency power division circuit 250F, and both the two inter-frequency power division subcircuits are configured to perform inter-frequency power division on the first radio frequency signal and the second radio frequency signal. In this case, the first inter-frequency power division circuit 250F may include a connecting microstrip line, a first inter-frequency power division subcircuit, and a second inter-frequency power division subcircuit. The first inter-frequency power division subcircuit is coupled to the second inter-frequency power division subcircuit through the connecting microstrip line. In this architecture, the first inter-frequency power division subcircuit and the second inter-frequency power division subcircuit are connected in different forms, and may have different inter-frequency power division manners. The following several examples are provided herein:

Example 1 of a connection relationship between the first inter-frequency power division subcircuit and the second inter-frequency power division subcircuit: As shown in FIG. 11, a first end of the connecting microstrip line LL is coupled to a combining port of the first inter-frequency power division subcircuit 251F, and a second end of the connecting microstrip line LL is coupled to a combining port of the second inter-frequency power division subcircuit 252F. The output port of the first auxiliary amplification circuit 230F is coupled to the combining port of the first inter-frequency power division subcircuit 251F. The output port of the first main amplification circuit 210F is coupled to a first division port of the first inter-frequency power division subcircuit 251F, and a second division port of the first inter-frequency power division subcircuit 251F is the second output port of the first inter-frequency power division circuit 250F. The output port of the second auxiliary amplification circuit 240F is coupled to the combining port of the second inter-frequency power division subcircuit 252F. The output port of the second main amplification circuit 220F is coupled to a first division port of the second inter-frequency power division subcircuit 252F, and a second division port of the second inter-frequency power division subcircuit 252F is the first output port of the first inter-frequency power division circuit 250F.

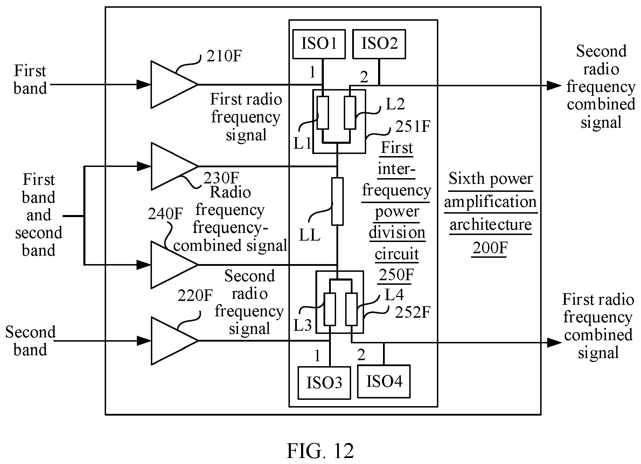

For example, as shown in FIG. 12, in the embodiment shown in FIG. 11, the first inter-frequency power division subcircuit 251F includes a first microstrip line L1, a second microstrip line L2, a first isolation circuit ISO1, and a second isolation circuit ISO2, and the second inter-frequency power division subcircuit 252F includes a third microstrip line L3, a fourth microstrip line L4, a third isolation circuit ISO3, and a fourth isolation circuit ISO4. A first end of the first microstrip line L1 and a first end of the second microstrip line L2 are coupled to form a combining port of the first inter-frequency power division subcircuit 251F. A second end of the first microstrip line L1 is used as the first division port of the first inter-frequency power division subcircuit 251F. A second end of the second microstrip line L2 is used as the second division port of the first inter-frequency power division subcircuit 251F. A first end of the third microstrip line L3 and a first end of the fourth microstrip line L4 are coupled to form the combining port of the second inter-frequency power division subcircuit 252F. A second end of the third microstrip line L3 is used as the first division port of the second inter-frequency power division subcircuit 252F. A second end of the fourth microstrip line L4 is used as the second division port of the second inter-frequency power division subcircuit 252F. The first isolation circuit ISO1 is coupled to the first division port of the first inter-frequency power division subcircuit 251F, the second isolation circuit ISO2 is coupled to the second division port of the first inter-frequency power division subcircuit 251F, the third isolation circuit ISO3 is coupled to the first division port of the second inter-frequency power division subcircuit 252F, and the fourth isolation circuit ISO4 is coupled to the second division port of the second inter-frequency power division subcircuit 252F. The first isolation circuit ISO1 presents a short-circuit characteristic to the second radio frequency signal, and presents an open-circuit characteristic to the first radio frequency signal. The second isolation circuit ISO2 presents a short-circuit characteristic to the first radio frequency signal, and presents an open-circuit characteristic to the second radio frequency signal. The third isolation circuit ISO3 presents a short-circuit characteristic to the first radio frequency signal, and presents an open-circuit characteristic to the second radio frequency signal. The fourth isolation circuit ISO4 presents a short-circuit characteristic to the second radio frequency signal, and presents an open-circuit characteristic to the first radio frequency signal.

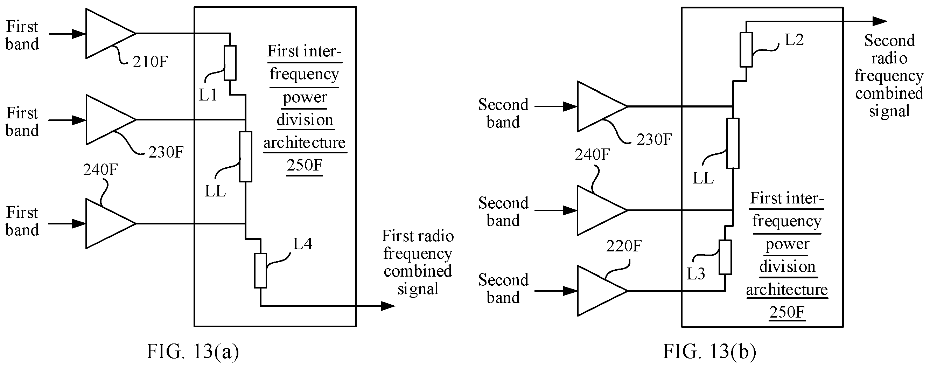

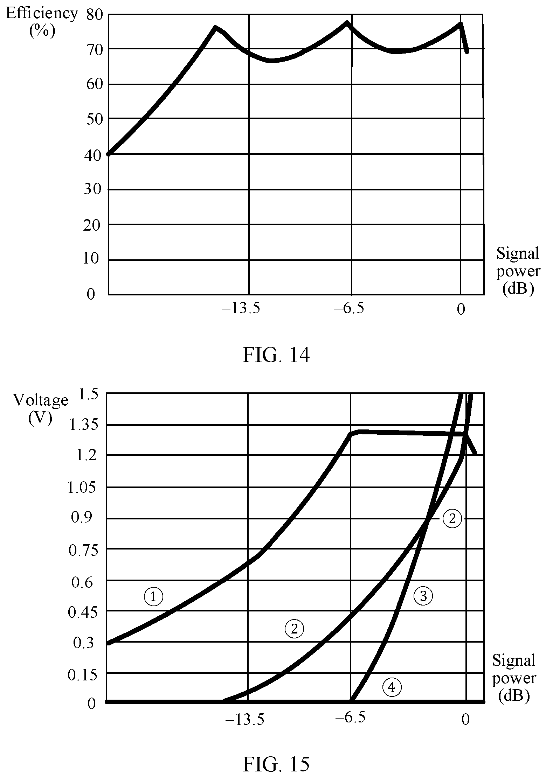

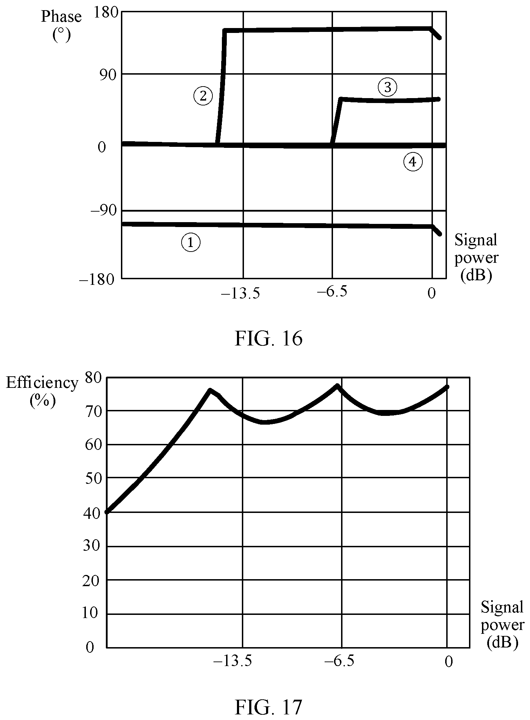

For example, in the structures shown in FIG. 11 and FIG. 12, only the radio frequency signal of the first band is input. The first main amplification circuit 210F, the first auxiliary amplification circuit 230F, and the second auxiliary amplification circuit 240F input radio frequency signals of the first band. When no radio frequency signal of the second band is input, the second main amplification circuit 220F does not operate. A power-amplified radio frequency frequency-combined signal that is output by the first auxiliary amplification circuit 230F and the second auxiliary amplification circuit 240F includes only a power-amplified first radio frequency signal. In this case, the circuit in FIG. 12 may be equivalent to a structure shown in FIG. 13(a), and the structure is used to perform power amplification on the radio frequency signal of the first band. When the first main amplification circuit 210F starts to operate, and the first auxiliary amplification circuit 230F and the second auxiliary amplification circuit 240F do not start to operate, an output first radio frequency combined signal includes only one first radio frequency signal output by the first main amplification circuit 210F. When the first auxiliary amplification circuit 230F and/or the second auxiliary amplification circuit 240F is also started to operate, the output first radio frequency combined signal is a signal obtained by power combination on a plurality of first radio frequency signals. For example, the first band is 1.8 GHz. FIG. 14 is a diagram of a response relationship between a power backoff amount and operating efficiency in the first band in the architecture in FIG. 12. FIG. 15 is a diagram of a response relationship between signal amplitudes of the amplification circuits and input power in the first band in the architecture in FIG. 12. In the figure, for example, the first auxiliary amplification circuit 230F starts to operate before the second auxiliary amplification circuit 240F. A line ① is a voltage change of the first main amplification circuit 210F, a line ② is a voltage change of the first auxiliary amplification circuit 230F, a line ③ is a voltage change of the second auxiliary amplification circuit 240F, and a line ④ is a voltage change of the second main amplification circuit 220F. FIG. 16 is a diagram of a response relationship between signal phases of the amplification circuits and input power in the first band in the architecture in FIG. 12. In the figure, for example, the first auxiliary amplification circuit 230F starts to operate before the second auxiliary amplification circuit 240F. A line ① is a phase change of the first main amplification circuit 210F, a line ② is a phase change of the first auxiliary amplification circuit 230F, a line ③ is a phase change of the second auxiliary amplification circuit 240F, and a line ④ is a phase change of the second main amplification circuit 220F. As shown in FIG. 14, FIG. 15, and FIG. 16, it can be learned that in embodiments shown in FIG. 11 and FIG. 12, for a radio frequency signal of the first band, the sixth multi-way power amplification architecture 200F has two high-efficiency points respectively when an input radio frequency power is backed off by 6.5 dB and 13.5 dB, and keeps operating in a state of a conventional three-way Doherty circuit shown in FIG. 5(a) and FIG. 13(a).

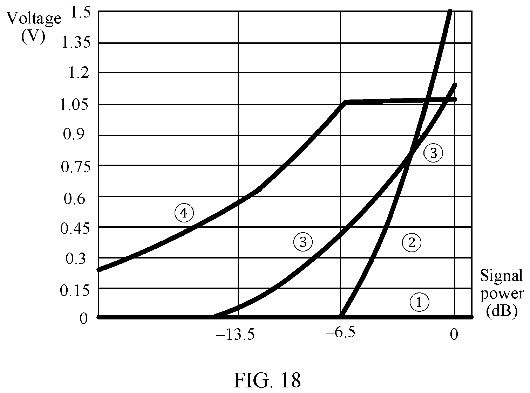

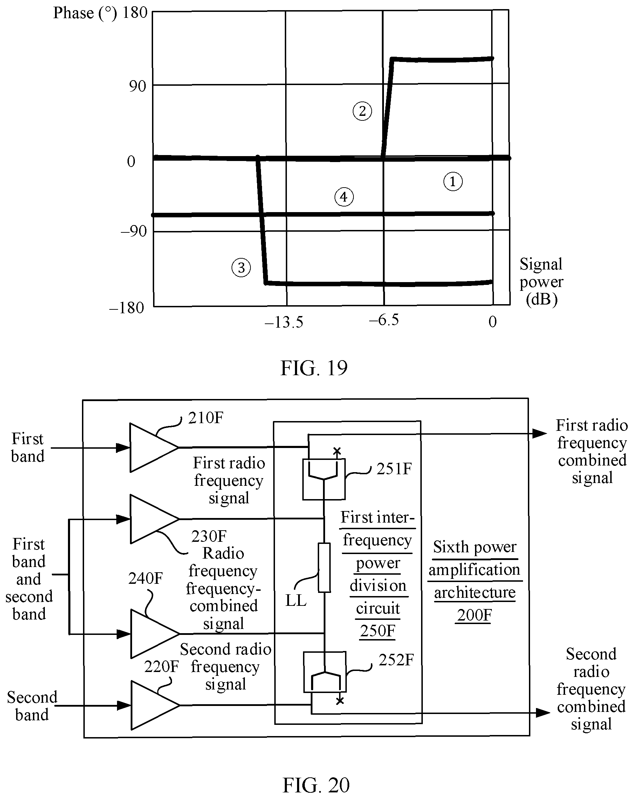

For example, in the structure shown in FIG. 12, only the radio frequency signal of the second band is input. The second main amplification circuit 220F, the first auxiliary amplification circuit 230F, and the second auxiliary amplification circuit 240F input radio frequency signals of the second band. When no radio frequency signal of the first band is input, the first main amplification circuit 210F does not operate. A power-amplified radio frequency frequency-combined signal that is output by the first auxiliary amplification circuit 230F and the second auxiliary amplification circuit 240F includes only a power-amplified second radio frequency signal. In this case, the circuit in FIG. 12 may be equivalent to a structure shown in FIG. 13(b), and the structure is used to perform power amplification on the radio frequency signal of the second band. When the second main amplification circuit 220F starts to operate, and the first auxiliary amplification circuit 230F and the second auxiliary amplification circuit 240F do not start to operate, an output second radio frequency combined signal includes only one second radio frequency signal output by the second main amplification circuit 220F. When the first auxiliary amplification circuit 230F and/or the second auxiliary amplification circuit 240F is also started to operate, the output second radio frequency combined signal is a signal obtained by power combination on a plurality of second radio frequency signals. For example, the second band is 2.2 GHz. FIG. 17 is a diagram of a response relationship between a power backoff amount and operating efficiency in the second band in the architecture in FIG. 12. FIG. 18 is a diagram of a response relationship between signal amplitudes of the amplification circuits and input power in the second band in the architecture in FIG. 12. For example, the first auxiliary amplification circuit 230F starts to operate after the second auxiliary amplification circuit 240F. A line ① is a voltage change of the first main amplification circuit 210F, a line ② is a voltage change of the first auxiliary amplification circuit 230F, a line ③ is a voltage change of the second auxiliary amplification circuit 240F, and a line ④ is a voltage change of the first main amplification circuit 220F. FIG. 19 is a diagram of a response relationship between signal phases of the amplification circuits and input power in the second band in the architecture in FIG. 12. For example, the first auxiliary amplification circuit 230F starts to operate after the second auxiliary amplification circuit 240F. A line ① is a phase change of the first main amplification circuit 210F, a line ② is a phase change of the first auxiliary amplification circuit 230F, a line ③ is a phase change of the second auxiliary amplification circuit 240F, and a line ④ is a phase change of the first main amplification circuit 220F. As shown in FIG. 17, FIG. 18, and FIG. 19, it can be learned that in embodiments shown in FIG. 11 and FIG. 12, for a radio frequency signal of the second band, the sixth multi-way power amplification architecture 200F has two high-efficiency points respectively when an input radio frequency power is backed off by 6.5 dB and 13.5 dB, and keeps operating in a state of a conventional three-way Doherty circuit shown in FIG. 5(a) and FIG. 13(b).

For example, radio frequency signals of the first band and the second band are input at the same time in the structure shown in FIG. 12. As shown in FIG. 12, the first isolation circuit ISO1 presents a short-circuit characteristic to the second radio frequency signal, and presents an open-circuit characteristic to the first radio frequency signal, so that the first division port of the first inter-frequency power division subcircuit 251F presents a stopband characteristic to the second radio frequency signal, and presents a passband characteristic to the first radio frequency signal. Therefore, based on open-circuit characteristics and short-circuit characteristics corresponding to the first isolation circuit ISO1, the second isolation circuit ISO2, the third isolation circuit ISO3, and the fourth isolation circuit ISO4, absorption and isolation of the first radio frequency signal or the second radio frequency signal may be implemented at corresponding positions, so that when the radio frequency signals of the first band and the second band are input at the same time, load-pull and power combination effect in the structure shown in FIG. 13(a) and FIG. 13(b) can be implemented without mutual interference in the first band and the second band.

In conclusion, in the structures of embodiments shown in FIG. 11 and FIG. 12, dual-frequency shared power combination in a multi-way Doherty architecture may be implemented based on a microstrip line structure. In addition, when a microstrip line is used to implement inter-frequency power division, a device area can be greatly reduced, and a limitation of an impedance characteristic of an inter-frequency power division structure of a bridge structure on design matching can be eliminated. In addition, it is more convenient to improve a design for another power amplification structure, and it is convenient to add and expand another power amplification structure to implement a design of more branches. In addition, as shown in FIG. 12, a narrowband isolator may be used to perform isolation processing, and power combination processing is performed after the isolator. In this case, problems of a large insertion loss and poor linearity caused by a wideband isolator can be avoided. In addition, because a width isolator isolator is also difficult to design, avoiding using the width isolator can also reduce the design difficulty.

Example 2 of a connection relationship between the first inter-frequency power division subcircuit and the second inter-frequency power division subcircuit: One of the two inter-frequency power division subcircuits of the first inter-frequency power division circuit 250F is configured to implement power combination of the first radio frequency signals, and the other inter-frequency power division subcircuit is configured to implement power combination of the second radio frequency signals. In this case, as shown in FIG. 20, a first end of the connecting microstrip line LL is coupled to a combining port of the first inter-frequency power division subcircuit 251F, and a second end of the connecting microstrip line LL is coupled to a combining port of the second inter-frequency power division subcircuit 252F. The output port of the first auxiliary amplification circuit 230F is coupled to the combining port of the first inter-frequency power division subcircuit 251F, and the output port of the first main amplification circuit 210F and a first division port of the first inter-frequency power division subcircuit 251F are coupled to form the first output port of the first inter-frequency power division circuit 250F. The output port of the second auxiliary amplification circuit 240F is coupled to the combining port of the second inter-frequency power division subcircuit 252F, and the output port of the second main amplification circuit 220F and a first division port of the second inter-frequency power division subcircuit 252F are coupled to form the second output port of the first inter-frequency power division circuit 250F.

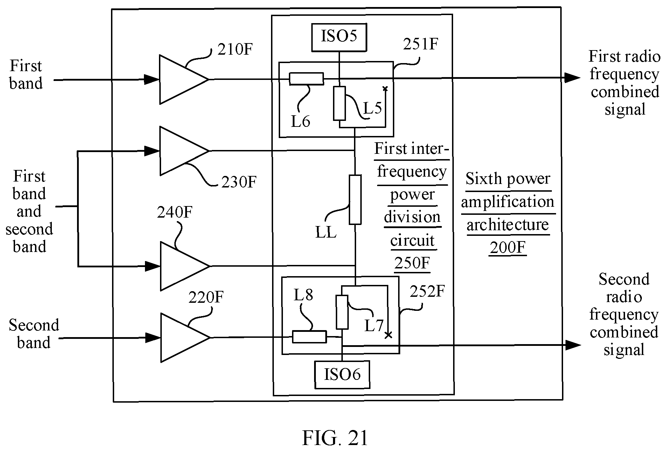

For example, as shown in FIG. 21, the first inter-frequency power division subcircuit 251F includes a fifth microstrip line L5, a sixth microstrip line L6, and a fifth isolation circuit ISO5, and the second inter-frequency power division subcircuit 252F includes a seventh microstrip line L7, an eighth microstrip line L8, and a sixth isolation circuit ISO6. A first end of the fifth microstrip line L5 is used as the combining port of the first inter-frequency power division subcircuit 251F, and a second end of the fifth microstrip line L5 is used as a first division port of the first inter-frequency power division subcircuit 251F. The output port of the first main amplification circuit 210F is coupled to a first end of the sixth microstrip line L6, and a second end of the sixth microstrip line L6 is coupled to the second end of the fifth microstrip line L5. A first end of the seventh microstrip line L7 is used as the combining port of the second inter-frequency power division subcircuit 252F, and a second end of the seventh microstrip line L7 is used as the first division port of the second inter-frequency power division subcircuit 252F. The output port of the second main amplification circuit 220F is coupled to a first end of the eighth microstrip line L8, and a second end of the eighth microstrip line L8 is coupled to the second end of the seventh microstrip line L7. The fifth isolation circuit ISO5 is coupled to the first division port of the first inter-frequency power division subcircuit 251F. The sixth isolation circuit ISO6 is coupled to the first division port of the second inter-frequency power division subcircuit 252F. The fifth isolation circuit ISO5 presents a short-circuit characteristic to the second radio frequency signal, and presents an open-circuit characteristic to the first radio frequency signal. The sixth isolation circuit ISO6 presents a short-circuit characteristic to the first radio frequency signal, and presents an open-circuit characteristic to the second radio frequency signal. In this embodiment of this application, the fifth isolation circuit ISO5 and the sixth isolation circuit ISO6 may be used to absorb or filter out a radio frequency signal that does not require power combination in an inter-frequency power division process.

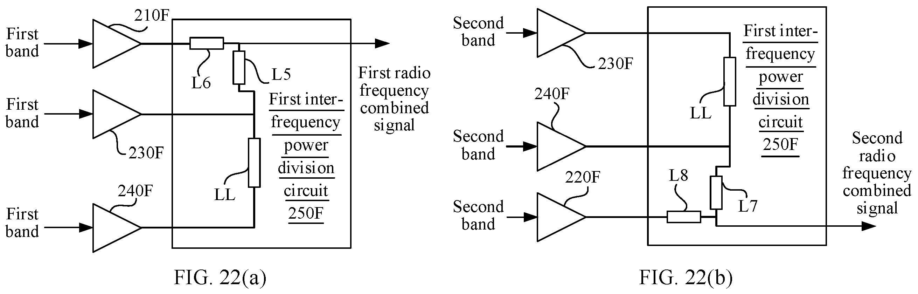

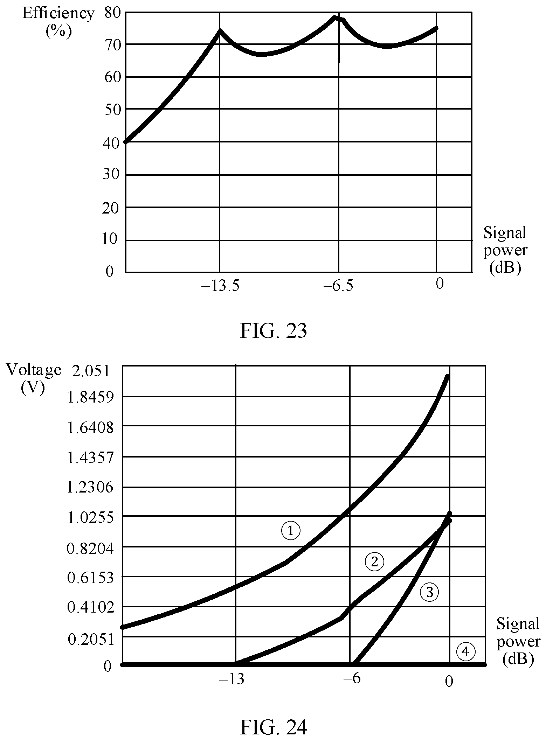

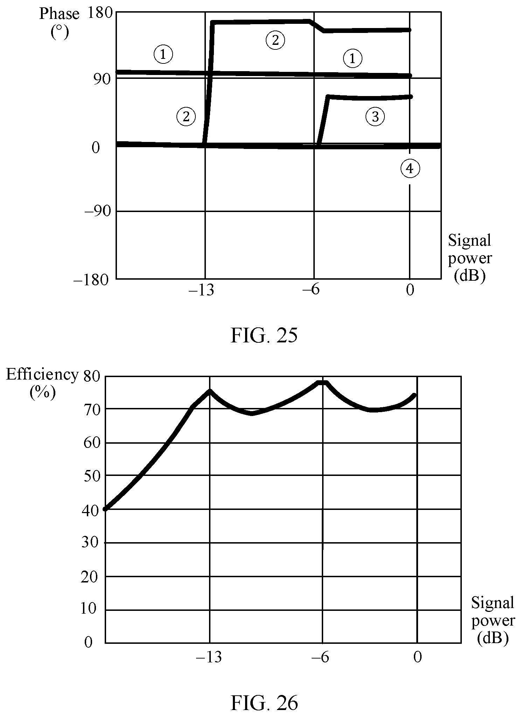

For example, only the first radio frequency signal of the first band is input in the structure shown in FIG. 21, a multi-way Doherty architecture in FIG. 22(a) may be equivalently obtained. A structure in FIG. 22(a) is an improved three-way Doherty architecture recorded in FIG. 5(b). Based on the open-circuit characteristics and the short-circuit characteristics of the fifth isolator ISO5 and the sixth isolator ISO6, for an operating principle of FIG. 22(a), refer to the descriptions of the operating principle of the improved three-way Doherty architecture in FIG. 5(b). Details are not described herein again. For example, the first band is 1.8 GHz. FIG. 23 is a diagram of a response relationship between a power backoff amount and operating efficiency in the first band in the architecture in FIG. 21. FIG. 24 is a diagram of a response relationship between signal amplitudes of the amplification circuits and input power in the first band in the architecture in FIG. 21. In the figure, for example, the first auxiliary amplification circuit 230F starts to operate before the second auxiliary amplification circuit 240F. A line ① is a voltage change of the first main amplification circuit 210F, a line ② is a voltage change of the first auxiliary amplification circuit 230F, a line ③ is a voltage change of the second auxiliary amplification circuit 240F, and a line ④ is a voltage change of the first main amplification circuit 220F. FIG. 25 is a diagram of a response relationship between signal phases of the amplification circuits and input power in the first band in the architecture in FIG. 21. In the figure, for example, the first auxiliary amplification circuit 230F starts to operate before the second auxiliary amplification circuit 240F. A line ① is a phase change of the first main amplification circuit 210F, a line ② is a phase change of the first auxiliary amplification circuit 230F, a line ③ is a phase change of the second auxiliary amplification circuit 240F, and a line ④ is a phase change of the first main amplification circuit 220F. As shown in FIG. 23, FIG. 24, and FIG. 25, it can be learned that in embodiments shown in FIG. 20 and FIG. 21, for a radio frequency signal of the first band, the sixth multi-way power amplification architecture 200F has two high-efficiency points respectively when an input radio frequency power is backed off by 6.5 dB and 13.5 dB, and keeps operating in a state of an improved three-way Doherty architecture shown in FIG. 5(b) and FIG. 22(a).

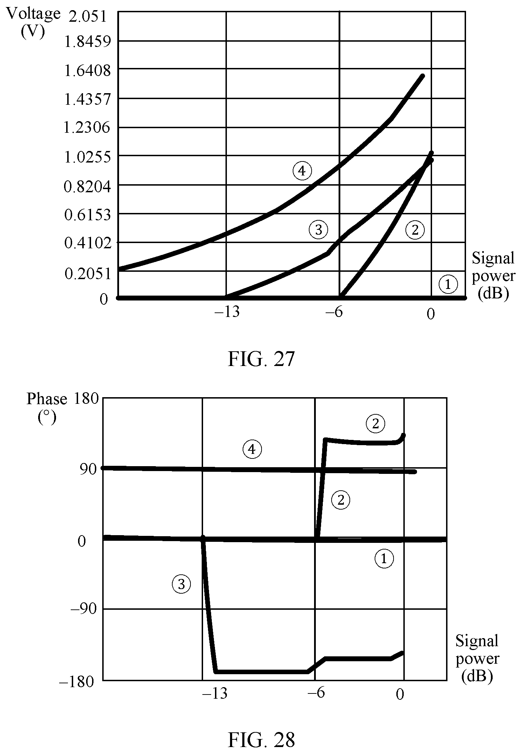

For a related principle of inputting only the second band or inputting both the first band and the second band in the structure shown in FIG. 21, refer to related descriptions of inputting the first band in the structure shown in FIG. 21, and related descriptions of open-circuit characteristics and short-circuit characteristics of the isolators in the embodiment shown in FIG. 12. Details are not described herein again. For example, the second band is 2.2 GHz. FIG. 26 is a diagram of a response relationship between a power backoff amount and operating efficiency in the second band in the architecture in FIG. 21. FIG. 27 is a diagram of a response relationship between signal amplitudes of the amplification circuits and input power in the second band in the architecture in FIG. 21. In the figure, for example, the first auxiliary amplification circuit 230F starts to operate after the second auxiliary amplification circuit 240F. A line ① is a voltage change of the first main amplification circuit 210F, a line ② is a voltage change of the first auxiliary amplification circuit 230F, a line ③ is a voltage change of the second auxiliary amplification circuit 240F, and a line ④ is a voltage change of the first main amplification circuit 220F. FIG. 28 is a diagram of a response relationship between signal phases of the amplification circuits and input power in the second band in the architecture in FIG. 21. In the figure, for example, the first auxiliary amplification circuit 230F starts to operate after the second auxiliary amplification circuit 240F. A line ① is a phase change of the first main amplification circuit 210F, a line ② is a phase change of the first auxiliary amplification circuit 230F, a line ③ is a phase change of the second auxiliary amplification circuit 240F, and a line ④ is a phase change of the first main amplification circuit 220F. As shown in FIG. 26, FIG. 27, and FIG. 28, it can be learned that in embodiments shown in FIG. 20 and FIG. 21, for a radio frequency signal of the second band, the sixth multi-way power amplification architecture 200F has two high-efficiency points respectively when an input radio frequency power is backed off by 6.5 dB and 13.5 dB, and keeps operating in a state of an improved three-way Doherty circuit shown in FIG. 5(b) and FIG. 22(b).

In this embodiment of this application, in the structures of embodiments shown in FIG. 20 and FIG. 21, dual-frequency shared power combination in the multi-way Doherty architecture may be implemented based on a microstrip line structure. In addition, when a microstrip line is used to implement inter-frequency power division, a device area can be greatly reduced, and a limitation of an impedance characteristic of an inter-frequency power division structure of a bridge structure on design matching can be eliminated. In addition, it is more convenient to improve a design for another power amplification structure, and it is convenient to add and expand another power amplification structure to implement a design of more branches. In addition, as shown in FIG. 21, a narrowband isolator may be used to perform isolation processing, and power combination processing is performed after the isolator. In this case, problems of a large insertion loss and poor linearity caused by a wideband isolator can be avoided. In addition, because a width isolator is also difficult to design, avoiding using the width isolator can also reduce the design difficulty.

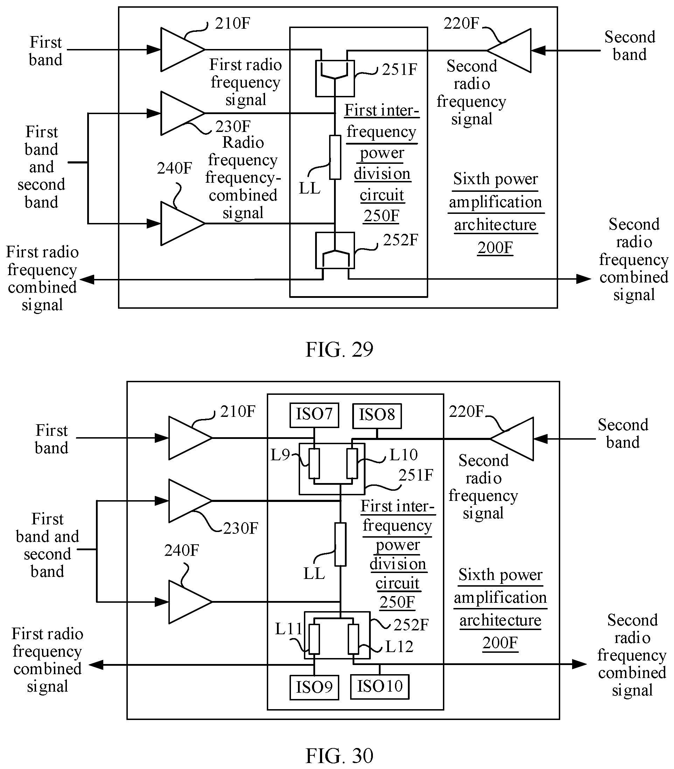

Example 3 of a connection relationship between the first inter-frequency power division subcircuit and the second inter-frequency power division subcircuit: One of the two inter-frequency power division subcircuits in the first inter-frequency power division circuit 250F is configured to implement inter-frequency power division of the first radio frequency signal and the second radio frequency signal that are output by the two main amplification circuits, and the other inter-frequency power division subcircuit is configured to implement inter-frequency power division of a first radio frequency combined signal and a second radio frequency combined signal that are obtained by power combination. In this case, as shown in FIG. 29, a first division port of the first inter-frequency power division subcircuit 251F is coupled to the output port of the first main amplification circuit 210F, a second division port of the first inter-frequency power division subcircuit 251F is coupled to the output port of the second main amplification circuit 220F, and a combining port of the first inter-frequency power division subcircuit 251F and the output port of the first auxiliary amplification circuit 230F are separately coupled to a first end of the connecting microstrip line LL. A combining port of the second inter-frequency power division subcircuit 252F and the output port of the second auxiliary amplification circuit 240F are separately coupled to a second end of the connecting microstrip line LL, a first division port of the second inter-frequency power division subcircuit 252F is used as the first output port of the first inter-frequency power division circuit 250F, and a second division port of the second inter-frequency power division subcircuit 252F is used as the second output port of the first inter-frequency power division circuit 250F.

For example, as shown in FIG. 30, the first inter-frequency power division subcircuit 251F includes a ninth microstrip line L9, a tenth microstrip line L10, a seventh isolation circuit ISO7, and an eighth isolation circuit ISO8. The second inter-frequency power division subcircuit 252F includes an eleventh microstrip line L11, a twelfth microstrip line L12, a ninth isolation circuit ISO9, and a tenth isolation circuit ISO10. A first end of the ninth microstrip line L9 is used as the first division port of the first inter-frequency power division subcircuit 251F, a second end of the ninth microstrip line L9 and a second end of the tenth microstrip line L10 are coupled to form the combining port of the first inter-frequency power division subcircuit 251F, and a first end of the tenth microstrip line L10 is used as a second division port of the first inter-frequency power division subcircuit 251F. A first end of the eleventh microstrip line L11 is used as the first division port of the second inter-frequency power division subcircuit 252F, a second end of the eleventh microstrip line L11 and a second end of the twelfth microstrip line L12 are coupled to form the combining port of the second inter-frequency power division subcircuit 252F, and a first end of the twelfth microstrip line L12 is used as the second division port of the second inter-frequency power division subcircuit 252F. The seventh isolation circuit ISO7 is coupled to the first division port of the first inter-frequency power division subcircuit 251F. The eighth isolation circuit ISO8 is coupled to the second division port of the first inter-frequency power division subcircuit 251F. The ninth isolation circuit ISO9 is coupled to the first division port of the second inter-frequency power division subcircuit 252F. The tenth isolation circuit ISO10 is coupled to the second division port of the second inter-frequency power division subcircuit 252F. The seventh isolation circuit ISO7 presents a short-circuit characteristic to the second radio frequency signal, and presents an open-circuit characteristic to the first radio frequency signal. The eighth isolation circuit ISO8 presents a short-circuit characteristic to the first radio frequency signal, and presents an open-circuit characteristic to the second radio frequency signal. The ninth isolation circuit ISO9 presents a short-circuit characteristic to the second radio frequency signal, and presents an open-circuit characteristic to the first radio frequency signal. The tenth isolation circuit ISO10 presents a short-circuit characteristic to the first radio frequency signal, and presents an open-circuit characteristic to the second radio frequency signal. In this embodiment of this application, a function of the first inter-frequency power division subcircuit 251F is to perform inter-frequency combination on the first radio frequency signal output by the first main amplification circuit 210F and the second radio frequency signal output by the second main amplification circuit 220F. In this case, the first division port of the first inter-frequency power division subcircuit 251F may implement a passband characteristic for the first radio frequency signal and a stopband characteristic for the second radio frequency signal through the seventh isolator ISO7, and the second division port of the first inter-frequency power division subcircuit 251F implements a passband characteristic for the second radio frequency signal and a stopband characteristic for the first radio frequency signal through the eighth isolator ISO8. Similarly, after the combining port of the first inter-frequency power division subcircuit 251F outputs the first radio frequency signal and/or the second radio frequency signal, power combination is performed on the output radio frequency signal by performing load-pull by the first auxiliary amplification circuit 230F and the second auxiliary amplification circuit 240F through the connecting microstrip line LL. The second inter-frequency power division subcircuit 252F needs to perform inter-frequency power division on the first radio frequency combined signal and the second radio frequency combined signal that are obtained by power combination, to output the first radio frequency combined signal and the second radio frequency combined signal respectively from the first division port and the second division port of the second inter-frequency power division circuit 252F. In this case, the ninth isolator ISO9 and the tenth isolator ISO10 also need to perform processing such as absorption and filtering on a radio frequency signal of a band that does not need to be output, to improve effect of inter-frequency power division.

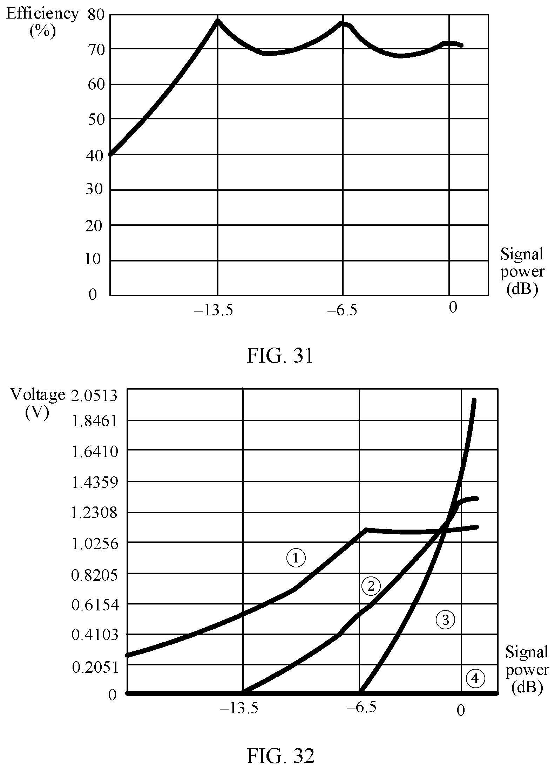

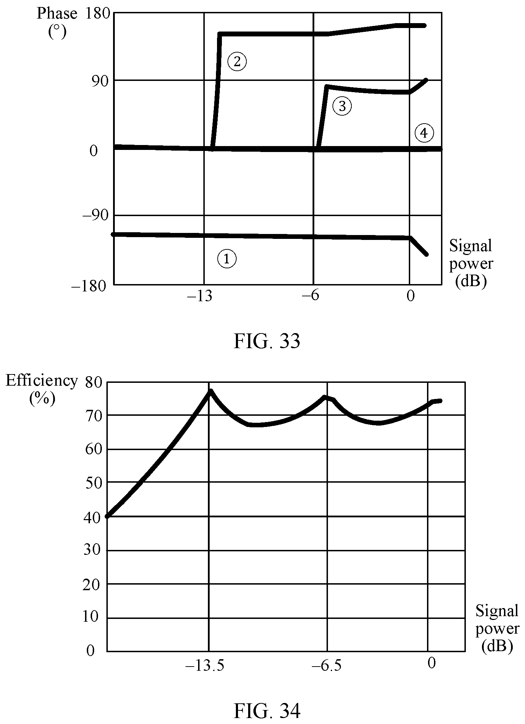

For example, only the first radio frequency signal of the first band is input in the structure shown in FIG. 30, and a structure similar to a multi-way Doherty architecture recorded in an embodiment in FIG. 22(a) may be equivalently obtained. A structure in FIG. 22(a) is an improved three-way Doherty architecture recorded in FIG. 5(b). Based on open-circuit characteristics and short-circuit characteristics of the seventh isolation circuit ISO7, the eighth isolation circuit ISO8, the ninth isolation circuit ISO9, and the tenth isolation circuit ISO10, for an operating principle of FIG. 22(a), refer to the descriptions of the operating principle of the improved three-way Doherty architecture in FIG. 5(b). Details are not described herein again. For example, the first band is 1.8 GHz. FIG. 31 is a diagram of a response relationship between a power backoff amount and operating efficiency in the first band in the architecture in FIG. 30. FIG. 32 is a diagram of a response relationship between signal amplitudes of the amplification circuits and input power in the first band in the architecture in FIG. 30. In the figure, for example, the first auxiliary amplification circuit 230F starts to operate before the second auxiliary amplification circuit 240F. A line ① is a voltage change of the first main amplification circuit 210F, a line ② is a voltage change of the first auxiliary amplification circuit 230F, a line ③ is a voltage change of the second auxiliary amplification circuit 240F, and a line ④ is a voltage change of the first main amplification circuit 220F. FIG. 33 is a diagram of a response relationship between signal phases of the amplification circuits and input power in the first band in the architecture in FIG. 30. In the figure, for example, the first auxiliary amplification circuit 230F starts to operate before the second auxiliary amplification circuit 240F. A line ① is a phase change of the first main amplification circuit 210F, a line ② is a phase change of the first auxiliary amplification circuit 230F, a line ③ is a phase change of the second auxiliary amplification circuit 240F, and a line ④ is a phase change of the first main amplification circuit 220F. As shown in FIG. 31, FIG. 32, and FIG. 33, it can be learned that in embodiments shown in FIG. 29 and FIG. 30, for a radio frequency signal of the first band, the sixth multi-way power amplification architecture 200F has two high-efficiency points respectively when an input radio frequency power is backed off by 6.5 dB and 13.5 dB, and keeps operating in a state of an improved three-way Doherty architecture shown in FIG. 5(b) and FIG. 22(a).

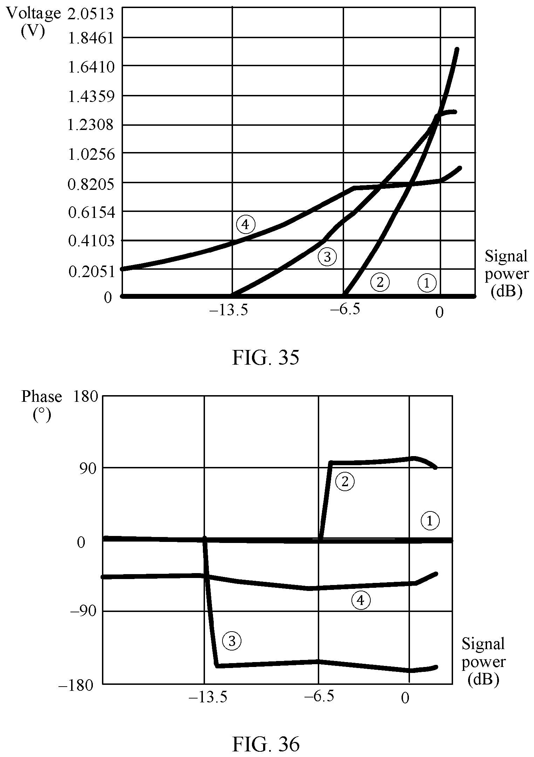

For a related principle of inputting only the second band or inputting both the first band and the second band in the structure shown in FIG. 30, refer to related descriptions of inputting the first band in the structure shown in FIG. 30, and related descriptions of open-circuit characteristics and short-circuit characteristics of the isolators in the embodiment shown in FIG. 12. Details are not described herein again. For example, the second band is 2.2 GHz. FIG. 34 is a diagram of a response relationship between a power backoff amount and operating efficiency in the second band in the architecture in FIG. 21. FIG. 35 is a diagram of a response relationship between signal amplitudes of the amplification circuits and input power in the second band in the architecture in FIG. 21. In the figure, for example, the first auxiliary amplification circuit 230F starts to operate after the second auxiliary amplification circuit 240F. A line ① is a voltage change of the first main amplification circuit 210F, a line ② is a voltage change of the first auxiliary amplification circuit 230F, a line ③ is a voltage change of the second auxiliary amplification circuit 240F, and a line ④ is a voltage change of the first main amplification circuit 220F. FIG. 36 is a diagram of a response relationship between signal phases of the amplification circuits and input power in the second band in the architecture in FIG. 21. In the figure, for example, the first auxiliary amplification circuit 230F starts to operate after the second auxiliary amplification circuit 240F. A line ① is a phase change of the first main amplification circuit 210F, a line ② is a phase change of the first auxiliary amplification circuit 230F, a line ③ is a phase change of the second auxiliary amplification circuit 240F, and a line ④ is a phase change of the first main amplification circuit 220F. As shown in FIG. 34, FIG. 35, and FIG. 36, it can be learned that in embodiments shown in FIG. 29 and FIG. 30, for a radio frequency signal of the second band, the sixth multi-way power amplification architecture 200F has two high-efficiency points respectively when an input radio frequency power is backed off by 6.5 dB and 13.5 dB, and keeps operating in a state of an improved three-way Doherty circuit shown in FIG. 5(b) and FIG. 22(b).

In this embodiment of this application, in the structures of embodiments shown in FIG. 29 and FIG. 30, dual-frequency shared power combination in the multi-way Doherty architecture may be implemented based on a microstrip line structure. In addition, when a microstrip line is used to implement inter-frequency power division, a device area can be greatly reduced, and a limitation of an impedance characteristic of an inter-frequency power division structure of a bridge structure on design matching can be eliminated. In addition, it is more convenient to improve a design for another power amplification structure, and it is convenient to add and expand another power amplification structure to implement a design of more branches. In addition, as shown in FIG. 30, a narrowband isolator may be used to perform isolation processing, and power combination processing is performed after the isolator. In this case, problems of a large insertion loss and poor linearity caused by a wideband isolator can be avoided. In addition, because a width isolator is also difficult to design, avoiding using the width isolator can also reduce the design difficulty.

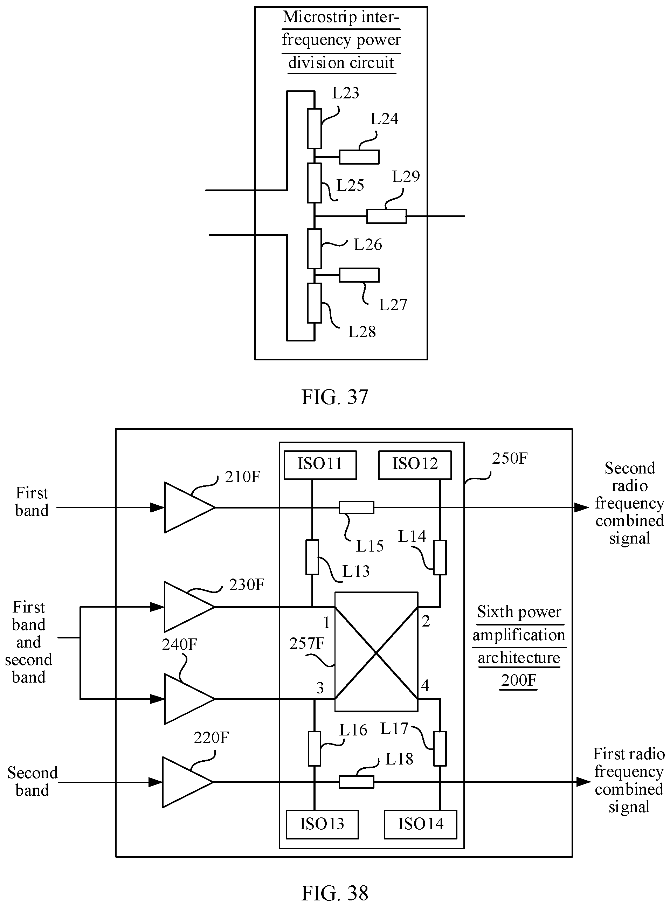

In some possible implementations, embodiments shown in FIG. 11, FIG. 20, and FIG. 29 may alternatively be a structure other than the structures recorded in FIG. 12, FIG. 21, and FIG. 30. For example, the first inter-frequency power division subcircuit 251F and/or the second inter-frequency power division circuit 252F in embodiments shown in FIG. 11, FIG. 20, and FIG. 29 may also be a microstrip inter-frequency power division circuit. As shown in FIG. 37, the microstrip inter-frequency power division circuit includes a twenty-third microstrip line L23, a twenty-fourth microstrip line L24, a twenty-fifth microstrip line L25, a twenty-sixth microstrip line L26, a twenty-seventh microstrip line L27, a twenty-eighth microstrip line L28, and a twenty-ninth microstrip line L29. Electrical lengths of the twenty-fourth microstrip line L24 and the twenty-fifth microstrip line L25 are a quarter wavelength of the second radio frequency signal. Electrical lengths of the twenty-sixth microstrip line L26 and the twenty-seventh microstrip line L27 are a quarter wavelength of the first radio frequency signal. A first end of the twenty-third microstrip line L23 is used as a first division port of the microstrip inter-frequency power division circuit, and a second end of the twenty-third microstrip line L23 is separately coupled to a first end of the twenty-fourth microstrip line L24 and a first end of the twenty-fifth microstrip line L25. A first end of the twenty-eighth microstrip line L28 is used as a second division port of the microstrip inter-frequency power division circuit, and a second end of the twenty-eighth microstrip line L28 is separately coupled to a first end of the twenty-seventh microstrip line L27 and a first end of the twenty-sixth microstrip line L26. A second end of the twenty-fifth microstrip line L25 and a second end of the twenty-sixth microstrip line L26 are separately coupled to a first end of the twenty-ninth microstrip line L29, and a second end of the twenty-ninth microstrip line L29 is used as a combining port of the microstrip inter-frequency power division circuit. In this embodiment of this application, the twenty-fourth microstrip line L24 and the twenty-fifth microstrip line L25 are microstrip lines with a quarter wavelength of the second band, so that a radio frequency signal of the second band at a node between the twenty-fifth microstrip line L25, the twenty-sixth microstrip line L26, and the twenty-ninth microstrip line L29 presents an open circuit to the upper part of the node. That is, the radio frequency signal of the second band can propagate only in a transmission direction between the twenty-sixth microstrip line L26 and the twenty-ninth microstrip line L29. The twenty-sixth microstrip line L26 and the twenty-seventh microstrip line L27 are microstrip lines with a quarter wavelength of the first band, so that a radio frequency signal of the first band at a node between the twenty-fifth microstrip line L25, the twenty-sixth microstrip line L26, and the twenty-ninth microstrip line L29 presents an open circuit to the lower part of the node. That is, the radio frequency signal of the first band can propagate only in a transmission direction between the twenty-fifth microstrip line L25 and the twenty-ninth microstrip line L29. In the foregoing manner, effect of inter-frequency power division can be equivalently achieved. The inter-frequency power division circuit implemented by using the microstrip line can improve integration and reduce area overheads.

In some possible implementations, in the embodiment shown in FIG. 10, the first inter-frequency power division circuit 250F may use a microstrip line-bridge structure, to implement power combination of the first radio frequency signals and power combination of the second radio frequency signals, and implement inter-frequency power division of two bands. In this case, as shown in FIG. 38, the first inter-frequency power division circuit 250F includes a coupling bridge 257F, a thirteenth microstrip line L13, a fourteenth microstrip line L14, a fifteenth microstrip line L15, a sixteenth microstrip line L16, a seventeenth microstrip line L17, an eighteenth microstrip line L18, an eleventh isolation circuit ISO11, a twelfth isolation circuit ISO12, a thirteenth isolation circuit ISO13, and a fourteenth isolation circuit ISO14. A first end of the thirteenth microstrip line L13 and a first end of the fifteenth microstrip line L15 are coupled to the eleventh isolation circuit ISO11 and then coupled to the output port of the first main amplification circuit 210F, and a second end of the thirteenth microstrip line L13 is separately coupled to the output port of the first auxiliary amplification circuit 230F and a first port of the coupling bridge 257F. A first end of the fourteenth microstrip line L14 and a second end of the fifteenth microstrip line L15 are coupled to the twelfth isolation circuit ISO12 and then used as the second output port of the first inter-frequency power division circuit 250F, and a second end of the fourteenth microstrip line L14 is coupled to a second port of the coupling bridge 257F. A first end of the sixteenth microstrip line L16 is separately coupled to the output port of the second auxiliary amplification circuit 240F and a third port of the coupling bridge 257F, and a second end of the sixteenth microstrip line L16 and a first end of the eighteenth microstrip line L18 are coupled to the thirteenth isolation circuit ISO13 and then coupled to the output port of the second main amplification circuit 210F. A first end of the seventeenth microstrip line L17 is coupled to a fourth port of the coupling bridge 257F, and a second end of the seventeenth microstrip line L17 and a second end of the eighteenth microstrip line L18 are coupled to the fourteenth isolation circuit ISO14 and then used as the first output port of the first inter-frequency power division circuit 250F. The eleventh isolation circuit ISO11 presents a short-circuit characteristic to the second radio frequency signal, and presents an open-circuit characteristic to the first radio frequency signal. The twelfth isolation circuit ISO12 presents a short-circuit characteristic to the first radio frequency signal, and presents an open-circuit characteristic to the second radio frequency signal. The thirteenth isolation circuit ISO13 presents a short-circuit characteristic to the first radio frequency signal, and presents an open-circuit characteristic to the second radio frequency signal. The fourteenth isolation circuit ISO14 presents a short-circuit characteristic to the second radio frequency signal, and presents an open-circuit characteristic to the first radio frequency signal. The first port and the second port of the coupling bridge 257F are coupled ports of each other, and the first port and the fourth port of the coupling bridge 257F are through ports of each other.

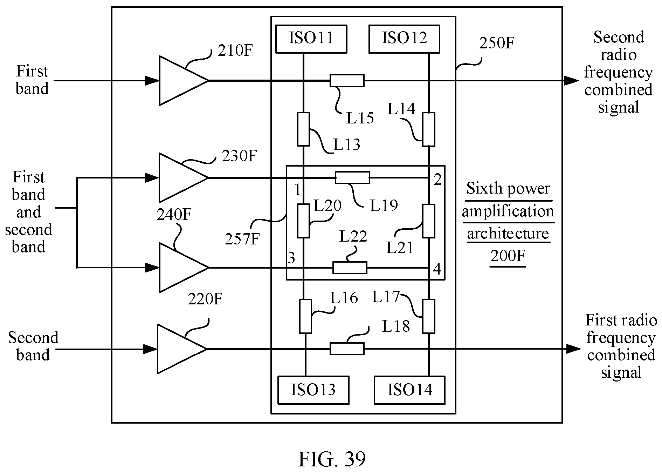

In some examples, as shown in FIG. 39, the coupling bridge 257F includes a nineteenth microstrip line L19, a twentieth microstrip line L20, a twenty-first microstrip line L21, and a twenty-second microstrip line L22. A first end of the nineteenth microstrip line L19 and a first end of the twentieth microstrip line L20 are coupled to form the first port of the coupling bridge 257F. A second end of the nineteenth microstrip line L19 and a first end of the twenty-first microstrip line L21 are coupled to form the second port of the coupling bridge 257F. A second end of the twentieth microstrip line L20 and a first end of the twenty-second microstrip line L22 are coupled to form the third port of the coupling bridge 257F. A second end of the twenty-first microstrip line L21 and a second end of the twenty-second microstrip line L22 are coupled to form the fourth port of the coupling bridge 257F.

FIG. 38 and FIG. 39 are diagrams of an example in which the coupling bridge 257F is a cross broadside coupler. In another embodiment, the coupling bridge 257F may alternatively be a branch-line coupler, a parallel broadside coupler, or the like. When the coupling bridge 257F is a branch-line coupler or a parallel broadside coupler, a connection direction of a port is not a connection direction shown in FIG. 38 and FIG. 39. However, regardless of a type of coupler of the coupling bridge 257F, a coupling principle described in the embodiment in FIG. 38 is followed: The first port and the second port of the coupling bridge 257F are coupled ports of each other, and the first port and the fourth port of the coupling bridge 257F are through ports of each other. In an actual application, whether a connection relationship in the coupling bridge 257F is the connection relationship recorded in this solution is determined based on a port location connection of the coupled ports, the through ports, and the like, instead of determining the connection relationship by using a relative connection direction between ports on a same side of the coupling bridge 257F.

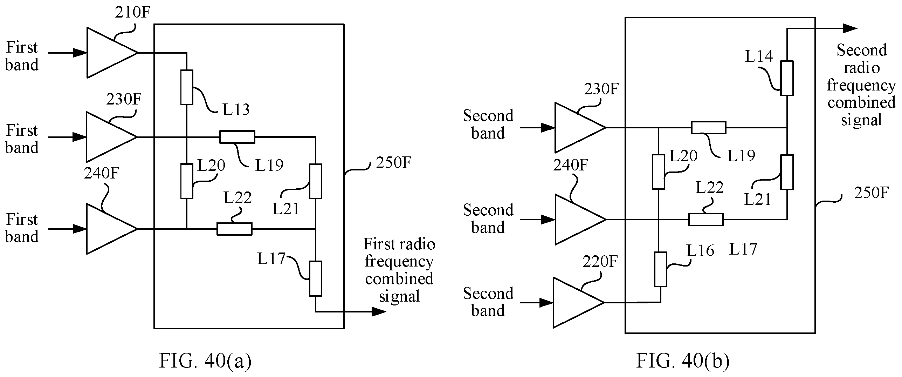

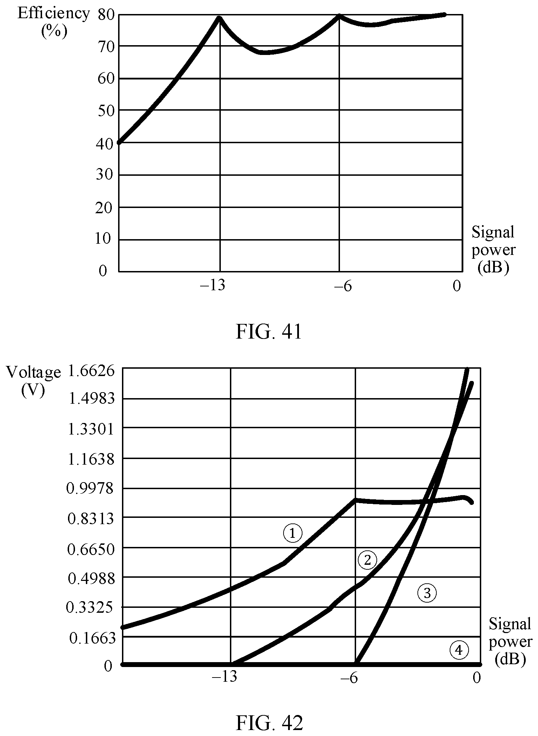

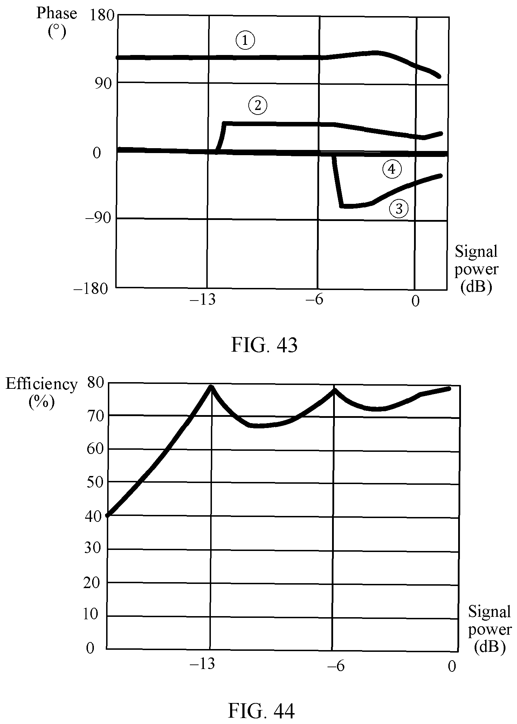

For example, only the first radio frequency signal of the first band is input in the structure shown in FIG. 39, a multi-way Doherty architecture in FIG. 40(a) may be equivalently obtained. The structure in FIG. 40(a) is an improved architecture for implementing a three-way Doherty architecture based on a bridge structure. Based on open-circuit characteristics and short-circuit characteristics of the eleventh isolation circuit ISO11, the twelfth isolation circuit ISO12, the thirteenth isolation circuit ISO13, and the fourteenth isolation circuit ISO14, a combination of a bridge and a microstrip line in FIG. 40(a) may implement load-pull and impedance change. For example, the first band is 1.8 GHz. FIG. 41 is a diagram of a response relationship between a power backoff amount and operating efficiency in the first band in the architecture in FIG. 39. FIG. 42 is a diagram of a response relationship between signal amplitudes of the amplification circuits and input power in the first band in the architecture in FIG. 39. In the figure, for example, the first auxiliary amplification circuit 230F starts to operate before the second auxiliary amplification circuit 240F. A line ① is a voltage change of the first main amplification circuit 210F, a line ② is a voltage change of the first auxiliary amplification circuit 230F, a line ③ is a voltage change of the second auxiliary amplification circuit 240F, and a line ④ is a voltage change of the first main amplification circuit 220F. FIG. 43 is a diagram of a response relationship between signal phases of the amplification circuits and input power in the first band in the architecture in FIG. 39. In the figure, for example, the first auxiliary amplification circuit 230F starts to operate before the second auxiliary amplification circuit 240F. A line ① is a phase change of the first main amplification circuit 210F, a line ② is a phase change of the first auxiliary amplification circuit 230F, a line ③ is a phase change of the second auxiliary amplification circuit 240F, and a line ④ is a phase change of the first main amplification circuit 220F. As shown in FIG. 41, FIG. 42, and FIG. 43, it can be learned that in embodiments shown in FIG. 38 and FIG. 39, for a radio frequency signal of the first band, the sixth multi-way power amplification architecture 200F has two high-efficiency points respectively when an input radio frequency power is backed off by 6 dB and 13 dB, and keeps operating in a state of an improved three-way Doherty architecture.

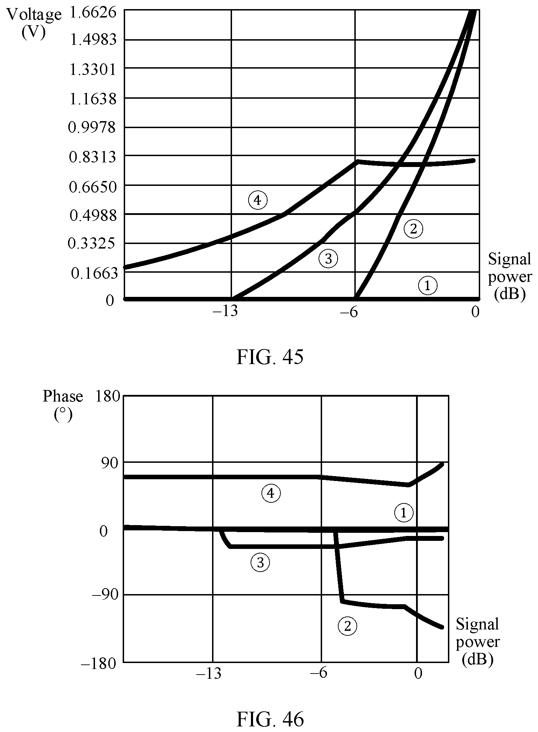

For a related principle of inputting only the second band or inputting both the first band and the second band in the structure shown in FIG. 39, refer to related descriptions of inputting the first band in the structure shown in FIG. 39, and related descriptions of open-circuit characteristics and short-circuit characteristics of the isolators in the embodiment shown in FIG. 12. Details are not described herein again. For example, the second band is 2.2 GHz. FIG. 44 is a diagram of a response relationship between a power backoff amount and operating efficiency in the second band in the architecture in FIG. 39. FIG. 45 is a diagram of a response relationship between signal amplitudes of the amplification circuits and input power in the second band in the architecture in FIG. 39. In the figure, for example, the first auxiliary amplification circuit 230F starts to operate after the second auxiliary amplification circuit 240F. A line ① is a voltage change of the first main amplification circuit 210F, a line ② is a voltage change of the first auxiliary amplification circuit 230F, a line ③ is a voltage change of the second auxiliary amplification circuit 240F, and a line ④ is a voltage change of the first main amplification circuit 220F. FIG. 46 is a diagram of a response relationship between signal phases of the amplification circuits and input power in the second band in the architecture in FIG. 39. In the figure, for example, the first auxiliary amplification circuit 230F starts to operate after the second auxiliary amplification circuit 240F. A line ① is a phase change of the first main amplification circuit 210F, a line ② is a phase change of the first auxiliary amplification circuit 230F, a line ③ is a phase change of the second auxiliary amplification circuit 240F, and a line ④ is a phase change of the first main amplification circuit 220F. A structure shown in FIG. 39 when only the second radio frequency signal of the second band is input may be equivalent to a multi-way Doherty architecture in FIG. 40(b). A structure in FIG. 40(b) is an improved architecture for implementing a three-way Doherty architecture based on a bridge structure. As shown in FIG. 44, FIG. 45, and FIG. 46, it can be learned that in embodiments shown in FIG. 38 and FIG. 39, for a radio frequency signal of the second band, the sixth multi-way power amplification architecture 200F has two high-efficiency points respectively when an input radio frequency power is backed off by 6 dB and 13 dB, and keeps operating in a state of an improved three-way Doherty circuit.

In some possible implementations, in embodiments shown in FIG. 10, FIG. 11, FIG. 20, FIG. 21, FIG. 29, FIG. 30, FIG. 38, and FIG. 39, the sixth multi-way power amplification architecture 200F is a dual-frequency dual-output architecture.

In some possible implementations, based on embodiments shown in FIG. 10, FIG. 11, FIG. 20, FIG. 21, FIG. 29, FIG. 30, FIG. 38, and FIG. 39, the sixth multi-way power amplification architecture 200F may alternatively be configured as a dual-frequency single-output architecture. In this case,
in some examples, a common inter-frequency power divider may receive the first radio frequency combined signal and the second radio frequency combined signal, and combine the first radio frequency combined signal and the second radio frequency combined signal into one output radio frequency signal.

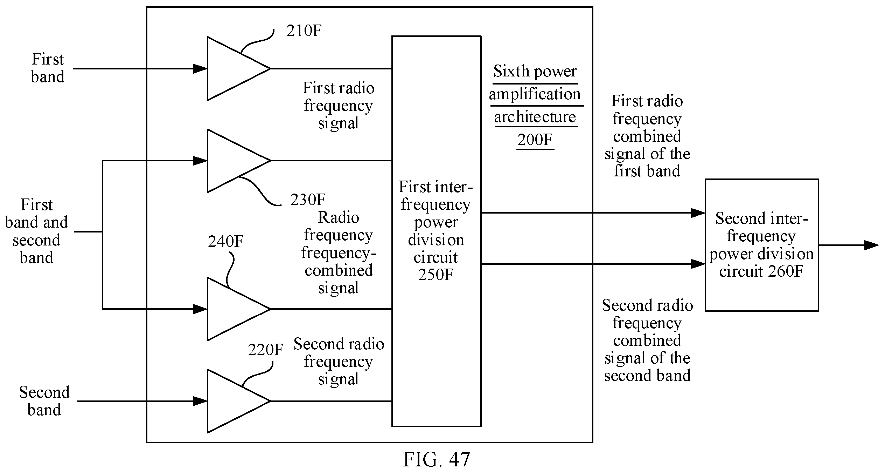

In some examples, a microstrip inter-frequency power division circuit may be designed based on a microstrip line to receive the first radio frequency combined signal and the second radio frequency combined signal, and combine the first radio frequency combined signal and the second radio frequency combined signal into one output radio frequency signal. In this case, as shown in FIG. 47, the sixth multi-way power amplification architecture 200F further includes a second inter-frequency power division circuit 260F, and the second inter-frequency power division circuit 260F includes a plurality of microstrip lines. The first output port of the first inter-frequency power division circuit 250F is coupled to a first division port of the second inter-frequency power division circuit 260F, and the first output port of the first inter-frequency power division circuit 250F is coupled to a second division port of the second inter-frequency power division circuit 260F. A combining port of the second inter-frequency power division circuit 260F is used to output any one of the following signals: the first radio frequency combined signal, the second radio frequency combined signal, and a combined signal of the first radio frequency combined signal and the second radio frequency combined signal. In this embodiment of this application, the first radio frequency combined signal and the second radio frequency combined signal may be input to the second inter-frequency power division circuit 260F based on the first division port and the second division port of the second inter-frequency power division circuit 260F, and are output as one signal through the combining port of the second inter-frequency power division circuit 260F.

For example, the second inter-frequency power division circuit 260F may be a conventional inter-frequency power divider. For example, the second inter-frequency power division circuit 260F may alternatively be a microstrip line equivalent structure recorded in the foregoing embodiments related to the first inter-frequency power division subcircuit 251F and the second inter-frequency power division subcircuit 252F. In the foregoing manner, effect of inter-frequency power division can be equivalently achieved. The inter-frequency power division circuit implemented by using the microstrip line can improve integration and reduce area overheads.

In some possible implementations, at least one of the first main amplification circuit 210F, the second main amplification circuit 210F, the first auxiliary amplification circuit 230F, and the second auxiliary amplification circuit 240F is a power combining circuit, and the power combining circuit includes a plurality of amplification branch circuits. For example, the power combining circuit includes at least one of the following: a Doherty circuit, an inverse Doherty circuit, an asymmetric Doherty circuit, an LMBA circuit, an SLMBA circuit, a balun voltage-type combining circuit, a Chireix amplification circuit, and an outphasing modulation and amplification circuit. In this embodiment of this application, when a power combination architecture is implemented based on an equivalent inter-frequency power division circuit based on a microstrip line, design difficulty of a power amplifier with a large backoff amount, high efficiency, and a large bandwidth can be reduced. In this case, a larger power backoff amount may be extended in the sixth multi-way power amplification architecture 200B in the foregoing embodiment. For example, at least one of the first main amplification circuit 210F, the second main amplification circuit 210F, the first auxiliary amplification circuit 230F, and the second auxiliary amplification circuit 240F is designed as a power combining circuit including a plurality of amplification branch circuits, to obtain a larger backoff power and more saturation power points on the basis of the three-way Doherty architecture.

In some examples, more power amplification branches may be added to the first output port and/or the second output port of the first inter-frequency power division circuit 250F, to perform power combination on the first radio frequency combined signal and/or the second radio frequency combined signal output by the sixth multi-way power amplification architecture 200B and a radio frequency signal output by another added power amplification branch. In this embodiment of this application, because design difficulty of a power amplifier with a large backoff amount, high efficiency, and a large power bandwidth is reduced after the microstrip line is used, more power combining architectures may also be designed and added to a subsequent of the output port of the first inter-frequency power division circuit 250F.

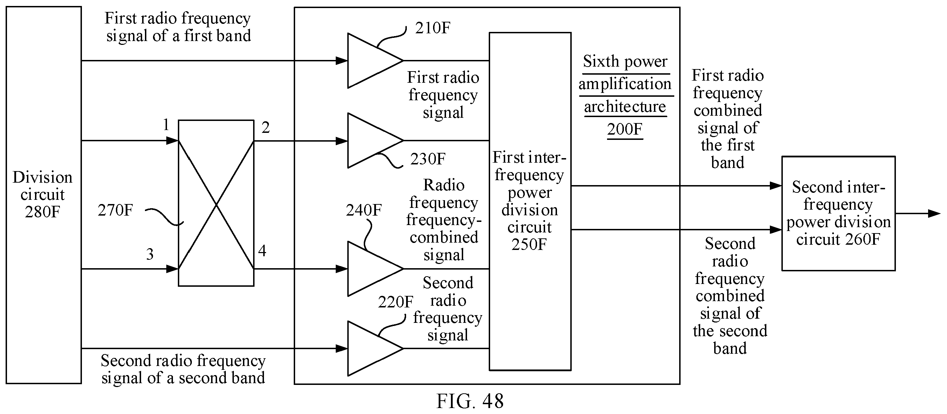

In some possible implementations, as shown in FIG. 48, the sixth multi-way power amplification architecture 200F further includes a division circuit 280F and a first coupler 270F. The division circuit is configured to 280F: input the first radio frequency signal and the second radio frequency signal, separately output the first radio frequency signal to an input port of the first main amplification circuit 210F and a first port of the first coupler 270F, and separately output the second radio frequency signal to an input port of the second main amplification circuit 210F and a third port of the first coupler 270F. A second port of the first coupler 270F and a fourth port of the first coupler 270F are used to separately output the radio frequency frequency-combined signal to an input port of the first auxiliary amplification circuit 230F and an input port of the second auxiliary amplification circuit 240F.

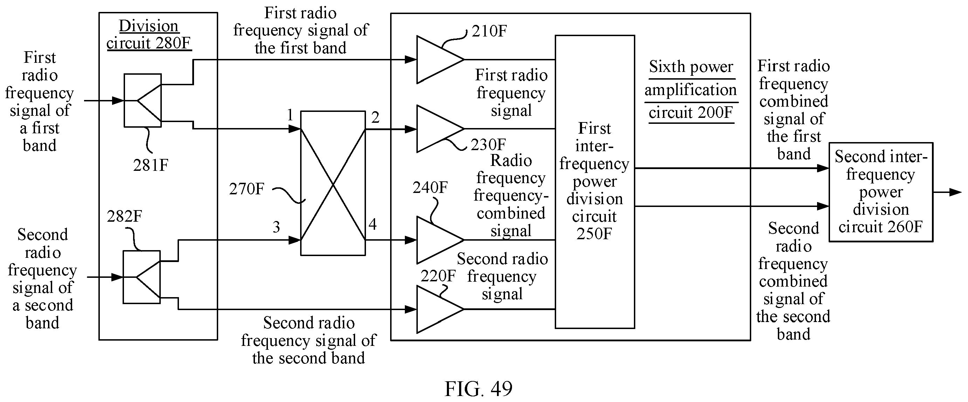

In some examples, as shown in FIG. 49, the division circuit 280F includes a first power divider 281F and a second power divider 282F. A combining port of the first power divider 281F is configured to input the first radio frequency signal. A first division port and a second division port of the first power divider 281F are separately used to output one first radio frequency signal. A combining port of the second power divider 282F is used to input the second radio frequency signal. A first division port and a second division port of the second power divider 282F are separately used to output one second radio frequency signal.

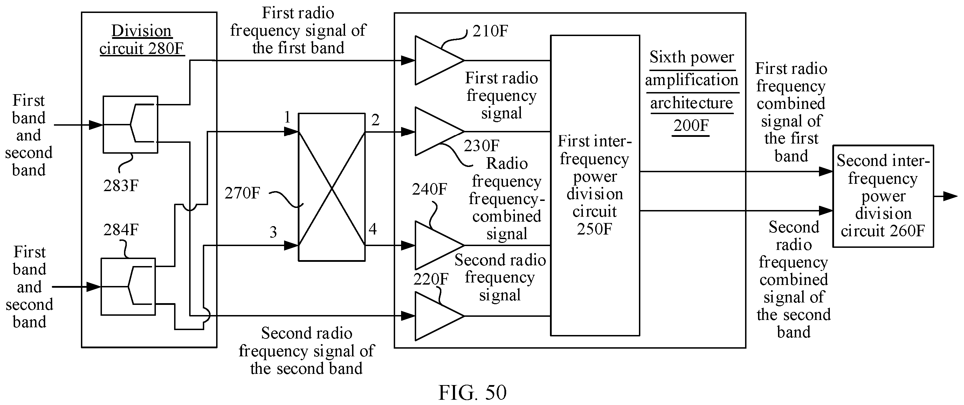

In some examples, as shown in FIG. 50, the division circuit 280F includes a first inter-frequency power divider 283F and a second inter-frequency power divider 284F, and the first inter-frequency power divider 283F and/or the second inter-frequency power divider 284F include a plurality of microstrip lines. A combining port of the first inter-frequency power divider 283F is used to input the first radio frequency signal and the second radio frequency signal. A first division port of the first inter-frequency power divider 283F outputs one first radio frequency signal. A second division port of the first inter-frequency power divider 283F is used to output one second radio frequency signal. A combining port of the first inter-frequency power divider 283F is used to input the first radio frequency signal and the second radio frequency signal. A first division port of the second inter-frequency power divider 284F outputs one first radio frequency signal. A second division port of the second inter-frequency power divider 284F is used to output one second radio frequency signal. In this embodiment of this application, the first inter-frequency power divider 283F and the second inter-frequency power divider 284F may also use a microstrip line-based equivalent structure, to reduce area overheads and improve device integration. For example, a structure of a microstrip line-based inter-frequency power division circuit shown in FIG. 50 may be used.

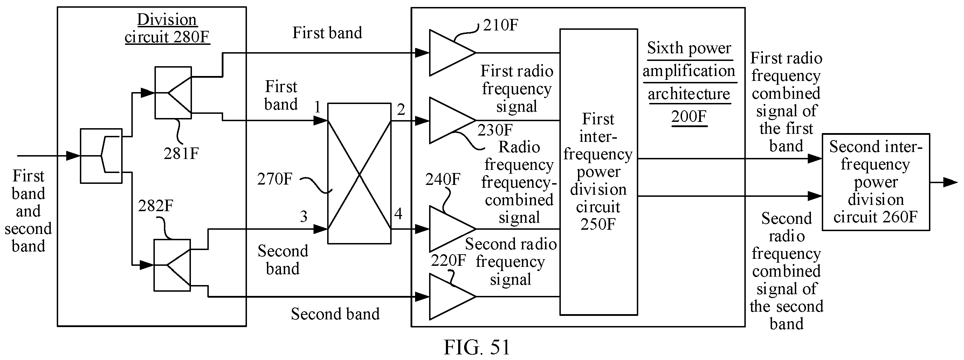

In some examples, as shown in FIG. 51, the division circuit 280F includes a third inter-frequency power divider 285F, a third power divider 286F, and a fourth power divider 287F. A first division port and a second division port of the third inter-frequency power divider 285F are respectively coupled to a combining port of the third power divider 286F and a combining port of the fourth power divider 287F. The third inter-frequency power divider 285F includes a plurality of microstrip lines. A combining port of the third inter-frequency power divider 285F is used to input the first radio frequency signal and the second radio frequency signal. The first division port of the third inter-frequency power divider 285F is used to output the first radio frequency signal. The second division port of the third inter-frequency power divider 285F is used to output the second radio frequency signal. A first division port and a second division port of the third power divider 286F are separately used to output one first radio frequency signal. A first division port and a second division port of the fourth power divider 287F are separately used to output one second radio frequency signal. In this embodiment of this application, the third inter-frequency power divider 285F may also use a microstrip line-based equivalent structure, to reduce area overheads and improve device integration. For example, a structure of a microstrip line-based inter-frequency power division circuit shown in FIG. 50 may be used.

In some possible implementations, the first radio frequency signal and/or the second radio frequency signal includes a radio frequency signal of at least one subband. In this embodiment of this application, one radio frequency signal with a large bandwidth may be divided into a plurality of first radio frequency signals and second radio frequency signals with small bandwidths. In a smaller relative bandwidth, convergence of an impedance design is more friendly, and efficiency of each amplification branch can be further improved, to improve backoff efficiency and full-load efficiency of the multi-way power amplification architecture. In addition, a conventional wideband main amplification circuit is divided into a plurality of radio frequency signals with small bandwidths, so that a difficulty in VBW design in a concurrency scenario can be avoided, and concurrency performance is not degraded.

For example, the first radio frequency signal may be located at 1.8 GHz, and the second radio frequency signal may be located at 2.1 GHz, 2.2 GHz, 2.6 GHz, or the like. For example, the first radio frequency signal may be located at three low frequencies (for example, 700 MHz, 800 MHz, and 900 MHz), and the second radio frequency signal may be located at three middle frequencies (for example, 1.8 GHz, 2.2 GHz, and 2.6 GHz). Alternatively, the first radio frequency signal and/or the second radio frequency signal may be located in another band. For example, the first radio frequency signal may include a first one of the three low frequencies, and the second radio frequency signal may include the other two of the three low frequencies. Alternatively, the first radio frequency signal may include two of the three low frequencies, and the second radio frequency signal may include the remaining one of the three low frequencies. For example, the first radio frequency signal may be located at two frequencies of 1.8 GHz and 2.2 GHz in the three middle frequencies, and the second radio frequency signal may be located at a single frequency of 2.6 GHz in the three middle frequencies. In this embodiment of this application, one main circuit is divided into two designs with smaller bandwidths. For example, a relative bandwidth of three middle frequencies in is 40%, and the three middle frequencies are divided into two frequencies of 1.8 GHz and 2.2 GHz (a relative bandwidth is 18%) and a single frequency of 2.6 GHz (a relative bandwidth is 3%). In a smaller relative bandwidth, convergence of an impedance design is more friendly, and efficiency of each amplification branch can be further improved, to improve backoff efficiency and full-load efficiency of the sixth multi-way power amplification architecture 200F.

In some possible implementations, a minimum operating power point of the first main amplification circuit 210F is less than a minimum operating power point of the first auxiliary amplification circuit 230F and a minimum operating power point of the second auxiliary amplification circuit 240F. A minimum operating power point of the second main amplification circuit 210F is less than the minimum operating power point of the first auxiliary amplification circuit 230F and the minimum operating power point of the second auxiliary amplification circuit 240F. The minimum operating power point of the first auxiliary amplification circuit 230F is less than, equal to, or greater than the minimum operating power point of the second auxiliary amplification circuit 240F. In this embodiment of this application, the first main amplification circuit 210F and the second main amplification circuit 220F may operate in the class AB. As power of an input radio frequency signal increases, the two main amplification circuits are first started to operate before the auxiliary amplification circuits. Therefore, the minimum operating power points of the two main amplification circuits are both less than the minimum operating power point of the first auxiliary amplification circuit 230F and the minimum operating power point of the second auxiliary amplification circuit 240F. However, in an actual application, the first auxiliary amplification circuit 230F may start to operate simultaneously with the second auxiliary amplification circuit 240F, or may start to operate before the second auxiliary amplification circuit 240F, or may start to operate after the second auxiliary amplification circuit 240F.

In some possible implementations, the sixth multi-way power amplification architecture 200F further includes a drive circuit or a control circuit, and the minimum operating power points of the first main amplification circuit 210F, the second main amplification circuit 210F, the first auxiliary amplification circuit 230F, and the second auxiliary amplification circuit 240F are controlled based on the drive circuit or the control circuit. In this embodiment of this application, a turn-on sequence of the first auxiliary amplification circuit 230F and the second auxiliary amplification circuit 240F in a same architecture may alternatively be reversed (for example, in an architecture, for a radio frequency signal of the first band, the first auxiliary amplification circuit 230F may be turned on before the second auxiliary amplification circuit 240F, but for a radio frequency signal of the second band, the second auxiliary amplification circuit 240F may be turned on before the first auxiliary amplification circuit 230F). Therefore, the drive circuit or the control circuit in a digital domain may be used to control the minimum operating power points of the first main amplification circuit 210F, the second main amplification circuit 210F, the first auxiliary amplification circuit 230F, and the second auxiliary amplification circuit 240F, to control the turn-on sequence.

In some possible implementations, at least one of the plurality of microstrip lines is a microstrip line in a three-dimensional stacked structure. For example, the microstrip line may be a suspended microstrip line. In this embodiment of this application, performance of a microstrip line in the three-dimensional stacked structure is consistent with that of a common microstrip line, but an area of the microstrip line is far less than that of the common microstrip line. The microstrip line in the three-dimensional stacked structure can reduce more area overheads of the multi-way power amplification architecture.

Embodiments of this application provide a multi-way power amplification architecture, a radio frequency generation device, and a communication system. First, the multi-way power amplification architecture implements load-pull and inter-frequency power division based on a microstrip line, to reduce a design difficulty caused by an impedance characteristic of a bridge, and improve design flexibility of the architecture. Second, the microstrip line reduces device area overheads and improves device integration. Third, when load-pull and inter-frequency power division are performed based on a microstrip line structure, a design requirement on an isolation circuit required for an inter-frequency power division function is reduced, and a narrowband isolator may be used as an isolation circuit, to avoid an insertion loss and a design difficulty caused by a wideband isolator. Fourth, when load-pull and inter-frequency power division are performed based on a microstrip line structure, this facilitates architecture expansion design, to obtain a larger backoff amount and the like. Fifth, this solution may implement different input and output forms such as single-frequency single-output, dual-frequency dual-output, and dual-frequency single-output in dual-frequency input. Sixth, in a case of dual-frequency sharing, a narrowband design may be performed on a band of a main circuit, to design optimal performance of a narrowband power amplifier, and further, impact of a multi-frequency concurrency characteristic on performance of the power amplifier may be eliminated. Seventh, in this solution, a conventional three-way Doherty architecture or an improved three-way Doherty architecture may be equivalently obtained, and may be selected according to an actual application requirement. In addition, an architecture may be further extended to a Doherty architecture with more ways. Eighth, as a quantity of branches of the Doherty architecture increases, a requirement on a quantity of impedance transformation lines and impedance inversion lines also increases. In this case, a larger area overhead proportion may be reduced according to the solution of the microstrip line equivalent structure described in the embodiments.

It should be understood that sequence numbers of the foregoing processes do not mean execution sequences in various embodiments of this application. The execution sequences of the processes should be determined according to functions and internal logic of the processes, and should not be construed as any limitation on the implementation processes of embodiments of this application.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In the several embodiments provided in this application, it should be understood that the disclosed system, device, and method may be implemented in other manners. For example, the described device embodiment is merely an example. For example, division into the modules is merely logical function division and may be other division in an actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate parts may or may not be physically separate, and parts displayed as modules may or may not be physical modules, that is, may be located in one device, or may be distributed on a plurality of devices. Some or all the modules may be selected according to actual needs to achieve the objectives of the solutions of embodiments.

In addition, functional modules in embodiments of this application may be integrated into one device, or each of the modules may exist alone physically, or two or more modules are integrated into one device.

All or some of the foregoing embodiments may be implemented by using software, hardware, firmware, or any combination thereof. When a software program is used to implement embodiments, embodiments may be implemented completely or partially in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk drive, or a magnetic tape), an optical medium (for example, a DVD), a semiconductor medium (for example, a solid-state drive (solid-state drive, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A multi-way power amplification architecture, comprising a first main amplification circuit, a second main amplification circuit, a first auxiliary amplification circuit, a second auxiliary amplification circuit, and a first inter-frequency power division circuit, wherein the first inter-frequency power division circuit comprises at least one microstrip line, and an output port of the first main amplification circuit, an output port of the second main amplification circuit, an output port of the first auxiliary amplification circuit, and an output port of the second auxiliary amplification circuit are separately coupled to the first inter-frequency power division circuit;
the output port of the first main amplification circuit is configured to output a first radio frequency signal, the output port of the second main amplification circuit is configured to output a second radio frequency signal, the first radio frequency signal and the second radio frequency signal have different frequencies, the output port of the first auxiliary amplification circuit and the output port of the second auxiliary amplification circuit are configured to output a radio frequency frequency-combined signal, and the radio frequency frequency-combined signal comprises the first radio frequency signal and/or the second radio frequency signal; and
a first output port of the first inter-frequency power division circuit is configured to assist in implementing power combination of the first radio frequency signal, and a second output port of the first inter-frequency power division circuit is configured to assist in implementing power combination of the second radio frequency signal.

2. The multi-way power amplification architecture according to claim 1, wherein the first inter-frequency power division circuit comprises a first inter-frequency power division subcircuit, a second inter-frequency power division subcircuit, and a connecting microstrip line, and the first inter-frequency power division subcircuit is coupled to the second inter-frequency power division subcircuit through the connecting microstrip line.

3. The multi-way power amplification architecture according to claim 2, wherein a first end of the connecting microstrip line is coupled to a combining port of the first inter-frequency power division subcircuit, and a second end of the connecting microstrip line is coupled to a combining port of the second inter-frequency power division subcircuit;
the output port of the first auxiliary amplification circuit is coupled to the combining port of the first inter-frequency power division subcircuit, the output port of the first main amplification circuit is coupled to a first division port of the first inter-frequency power division subcircuit, and a second division port of the first inter-frequency power division subcircuit is the second output port of the first inter-frequency power division circuit; and
the output port of the second auxiliary amplification circuit is coupled to the combining port of the second inter-frequency power division subcircuit, the output port of the second main amplification circuit is coupled to a first division port of the second inter-frequency power division subcircuit, and a second division port of the second inter-frequency power division subcircuit is the first output port of the first inter-frequency power division circuit.

4. The multi-way power amplification architecture according to claim 3, wherein the first inter-frequency power division subcircuit comprises a first microstrip line, a second microstrip line, a first isolation circuit, and a second isolation circuit, and the second inter-frequency power division subcircuit comprises a third microstrip line, a fourth microstrip line, a third isolation circuit, and a fourth isolation circuit;
a first end of the first microstrip line and a first end of the second microstrip line are coupled to form the combining port of the first inter-frequency power division subcircuit, a second end of the first microstrip line is used as the first division port of the first inter-frequency power division subcircuit, and a second end of the second microstrip line is used as the second division port of the first inter-frequency power division subcircuit;
a first end of the third microstrip line and a first end of the fourth microstrip line are coupled to form the combining port of the second inter-frequency power division subcircuit, a second end of the third microstrip line is used as the first division port of the second inter-frequency power division subcircuit, and a second end of the fourth microstrip line is used as the second division port of the second inter-frequency power division subcircuit;
the first isolation circuit is coupled to the first division port of the first inter-frequency power division subcircuit, the second isolation circuit is coupled to the second division port of the first inter-frequency power division subcircuit, the third isolation circuit is coupled to the first division port of the second inter-frequency power division subcircuit, and the fourth isolation circuit is coupled to the second division port of the second inter-frequency power division subcircuit;
the first isolation circuit presents a short-circuit characteristic to the second radio frequency signal, and presents an open-circuit characteristic to the first radio frequency signal;
the second isolation circuit presents a short-circuit characteristic to the first radio frequency signal, and presents an open-circuit characteristic to the second radio frequency signal;
the third isolation circuit presents a short-circuit characteristic to the first radio frequency signal, and presents an open-circuit characteristic to the second radio frequency signal; and
the fourth isolation circuit presents a short-circuit characteristic to the second radio frequency signal, and presents an open-circuit characteristic to the first radio frequency signal.

5. The multi-way power amplification architecture according to claim 2, wherein a first end of the connecting microstrip line is coupled to a combining port of the first inter-frequency power division subcircuit, and a second end of the connecting microstrip line is coupled to a combining port of the second inter-frequency power division subcircuit;
the output port of the first auxiliary amplification circuit is coupled to the combining port of the first inter-frequency power division subcircuit, the output port of the first main amplification circuit and a first division port of the first inter-frequency power division subcircuit are coupled to form the first output port of the first inter-frequency power division circuit; and
the output port of the second auxiliary amplification circuit is coupled to the combining port of the second inter-frequency power division subcircuit, the output port of the second main amplification circuit and a first division port of the second inter-frequency power division subcircuit are coupled to form the second output port of the first inter-frequency power division circuit.

6. The multi-way power amplification architecture according to claim 5, wherein the first inter-frequency power division subcircuit comprises a fifth microstrip line, a sixth microstrip line L6, and a fifth isolation circuit, and the second inter-frequency power division subcircuit comprises a seventh microstrip line L7, an eighth microstrip line L8, and a sixth isolation circuit;
a first end of the fifth microstrip line is used as the combining port of the first inter-frequency power division subcircuit, a second end of the fifth microstrip line is used as the first division port of the first inter-frequency power division subcircuit, and the output port of the first main amplification circuit is coupled to the second end of the fifth microstrip line through the sixth microstrip line;
a first end of the seventh microstrip line is used as the combining port of the second inter-frequency power division subcircuit, a second end of the seventh microstrip line is used as the first division port of the second inter-frequency power division subcircuit, and the output port of the second main amplification circuit is coupled to the second end of the seventh microstrip line through the eighth microstrip line;
the fifth isolation circuit is coupled to the first division port of the first inter-frequency power division subcircuit, and the sixth isolation circuit is coupled to the first division port of the second inter-frequency power division subcircuit;
the fifth isolation circuit presents a short-circuit characteristic to the second radio frequency signal, and presents an open-circuit characteristic to the first radio frequency signal; and
the sixth isolation circuit presents a short-circuit characteristic to the first radio frequency signal, and presents an open-circuit characteristic to the second radio frequency signal.

7. The multi-way power amplification architecture according to claim 2, wherein a first division port of the first inter-frequency power division subcircuit is coupled to the output port of the first main amplification circuit, a second division port of the first inter-frequency power division subcircuit is coupled to the output port of the second main amplification circuit, and a combining port of the first inter-frequency power division subcircuit and the output port of the first auxiliary amplification circuit are separately coupled to a first end of the connecting microstrip line; and
a combining port of the second inter-frequency power division subcircuit and the output port of the second auxiliary amplification circuit are separately coupled to a second end of the connecting microstrip line, a first division port of the second inter-frequency power division subcircuit is used as the first output port of the first inter-frequency power division circuit, and a second division port of the second inter-frequency power division subcircuit is used as the second output port of the first inter-frequency power division circuit.

8. The multi-way power amplification architecture according to claim 7, wherein the first inter-frequency power division circuit comprises a ninth microstrip line, a tenth microstrip line, a seventh isolation circuit, and an eighth isolation circuit, and the second inter-frequency power division circuit comprises an eleventh microstrip line, a twelfth microstrip line, a ninth isolation circuit, and a tenth isolation circuit;
a first end of the ninth microstrip line is used as the first division port of the first inter-frequency power division subcircuit, a second end of the ninth microstrip line and a second end of the tenth microstrip line are coupled to form the combining port of the first inter-frequency power division subcircuit, a first end of the tenth microstrip line is used as the second division port of the first inter-frequency power division subcircuit, a first end of the eleventh microstrip line is used as the first division port of the second inter-frequency power division subcircuit, a second end of the eleventh microstrip line and a second end of the twelfth microstrip line are coupled to form the combining port of the second inter-frequency power division subcircuit, and a first end of the twelfth microstrip line is used as the second division port of the second inter-frequency power division subcircuit;
the seventh isolation circuit is coupled to the first division port of the first inter-frequency power division subcircuit, the eighth isolation circuit is coupled to the second division port of the first inter-frequency power division subcircuit, the ninth isolation circuit is coupled to the first division port of the second inter-frequency power division subcircuit, and the tenth isolation circuit is coupled to the second division port of the second inter-frequency power division subcircuit;
the seventh isolation circuit presents a short-circuit characteristic to the second radio frequency signal, and presents an open-circuit characteristic to the first radio frequency signal;
the eighth isolation circuit presents a short-circuit characteristic to the first radio frequency signal, and presents an open-circuit characteristic to the second radio frequency signal;
the ninth isolation circuit presents a short-circuit characteristic to the second radio frequency signal, and presents an open-circuit characteristic to the first radio frequency signal; and
the tenth isolation circuit presents a short-circuit characteristic to the first radio frequency signal, and presents an open-circuit characteristic to the second radio frequency signal.

9. The multi-way power amplification architecture according to claim 3, 5, or 7, wherein the first inter-frequency power division subcircuit and/or the second inter-frequency power division subcircuit is a microstrip inter-frequency power division circuit; the microstrip inter-frequency power division circuit comprises a twenty-third microstrip line, a twenty-fourth microstrip line, a twenty-fifth microstrip line, a twenty-sixth microstrip line, a twenty-seventh microstrip line, a twenty-eighth microstrip line, and a twenty-ninth microstrip line; electrical lengths of the twenty-fourth microstrip line and the twenty-fifth microstrip line are a quarter wavelength of the second radio frequency signal; and electrical lengths of the twenty-sixth microstrip line and the twenty-seventh microstrip line are a quarter wavelength of the first radio frequency signal;
a first end of the twenty-third microstrip line is used as a first division port of the microstrip inter-frequency power division circuit, and a second end of the twenty-third microstrip line is separately coupled to a first end of the twenty-fourth microstrip line and a first end of the twenty-fifth microstrip line;
a first end of the twenty-eighth microstrip line is used as a second division port of the microstrip inter-frequency power division circuit, and a second end of the twenty-eighth microstrip line is separately coupled to a first end of the twenty-seventh microstrip line and a first end of the twenty-sixth microstrip line; and
a second end of the twenty-fifth microstrip line and a second end of the twenty-sixth microstrip line are separately coupled to a first end of the twenty-ninth microstrip line, and a second end of the twenty-ninth microstrip line is used as a combining port of the microstrip inter-frequency power division circuit.

10. The multi-way power amplification architecture according to claim 1, wherein the first inter-frequency power division circuit comprises a coupling bridge, a thirteenth microstrip line, a fourteenth microstrip line, a fifteenth microstrip line, a sixteenth microstrip line, a seventeenth microstrip line, an eighteenth microstrip line, an eleventh isolation circuit, a twelfth isolation circuit, a thirteenth isolation circuit, and a fourteenth isolation circuit;
a first end of the thirteenth microstrip line and a first end of the fifteenth microstrip line are coupled to the eleventh isolation circuit and then coupled to the output port of the first main amplification circuit, and a second end of the thirteenth microstrip line is separately coupled to the output port of the first auxiliary amplification circuit and a first port of the coupling bridge; and a first end of the fourteenth microstrip line and a second end of the fifteenth microstrip line are coupled to the twelfth isolation circuit and then used as the second output port of the first inter-frequency power division circuit, and a second end of the fourteenth microstrip line is coupled to a second port of the coupling bridge;
a first end of the sixteenth microstrip line is separately coupled to the output port of the second auxiliary amplification circuit and a third port of the coupling bridge, and a second end of the sixteenth microstrip line and a first end of the eighteenth microstrip line are coupled to the thirteenth isolation circuit and then coupled to the output port of the second main amplification circuit; and a first end of the seventeenth microstrip line is coupled to a fourth port of the coupling bridge, and a second end of the seventeenth microstrip line and a second end of the eighteenth microstrip line are coupled to the fourteenth isolation circuit and then used as the first output port of the first inter-frequency power division circuit;
the eleventh isolation circuit presents a short-circuit characteristic to the second radio frequency signal, and presents an open-circuit characteristic to the first radio frequency signal;
the twelfth isolation circuit presents a short-circuit characteristic to the first radio frequency signal, and presents an open-circuit characteristic to the second radio frequency signal;
the thirteenth isolation circuit presents a short-circuit characteristic to the first radio frequency signal, and presents an open-circuit characteristic to the second radio frequency signal;
the fourteenth isolation circuit presents a short-circuit characteristic to the second radio frequency signal, and presents an open-circuit characteristic to the first radio frequency signal; and
the first port and the second port of the coupling bridge are coupled ports of each other, and the first port and the fourth port of the coupling bridge are through ports of each other.

11. The multi-way power amplification architecture according to claim 10, wherein the coupling bridge comprises a nineteenth microstrip line, a twentieth microstrip line, a twenty-first microstrip line, and a twenty-second microstrip line;
a first end of the nineteenth microstrip line and a first end of the twentieth microstrip line are coupled to form the first port of the coupling bridge;
a second end of the nineteenth microstrip line and a first end of the twenty-first microstrip line are coupled to form the second port of the coupling bridge;
a second end of the twentieth microstrip line and a first end of the twenty-second microstrip line are coupled to form the third port of the coupling bridge; and
a second end of the twenty-first microstrip line and a second end of the twenty-second microstrip line are coupled to form the fourth port of the coupling bridge.

12. The multi-way power amplification architecture according to any one of claims 1 to 11, wherein the multi-way power amplification architecture further comprises a second inter-frequency power division circuit, the first output port of the first inter-frequency power division circuit is coupled to a first division port of the second inter-frequency power division circuit, the first output port of the first inter-frequency power division circuit is coupled to a second division port of the second inter-frequency power division circuit, a combining port of the second inter-frequency power division circuit is configured to output at least one of the following signals: a power-combined signal of the first radio frequency signal and a power-combined signal of the second radio frequency signal, and the second inter-frequency power division circuit is an inter-frequency power division circuit based on a microstrip line.

13. The multi-way power amplification architecture according to any one of claims 1 to 12, wherein at least one of the first main amplification circuit, the second main amplification circuit, the first auxiliary amplification circuit, and the second auxiliary amplification circuit is a power combining circuit, and the power combining circuit comprises a plurality of amplification branch circuits.

14. The multi-way power amplification architecture according to claim 13, wherein the power combining circuit comprises at least one of the following: a Doherty circuit, an inverse Doherty circuit, an asymmetric Doherty circuit, an LMBA circuit, an SLMBA circuit, a balun voltage-type combining circuit, a Chireix amplification circuit, and an outphasing modulation and amplification circuit.

15. The multi-way power amplification architecture according to any one of claims 1 to 14, wherein the multi-way power amplification architecture further comprises a division circuit and a first coupler;
the division circuit is configured to: input the first radio frequency signal and the second radio frequency signal, separately output the first radio frequency signal to an input port of the first main amplification circuit and a first port of the first coupler, and separately output the second radio frequency signal to an input port of the second main amplification circuit and a third port of the first coupler; and
a second port of the first coupler and a fourth port of the first coupler are configured to separately output the radio frequency frequency-combined signal to an input port of the first auxiliary amplification circuit and an input port of the second auxiliary amplification circuit.

16. The multi-way power amplification architecture according to claim 15, wherein the division circuit comprises a first inter-frequency power divider and a second inter-frequency power divider, and the first inter-frequency power divider and/or the second inter-frequency power divider is an inter-frequency power division circuit based on a microstrip line;
a combining port of the first inter-frequency power divider is configured to input the first radio frequency signal and the second radio frequency signal, a first division port of the first inter-frequency power divider outputs one first radio frequency signal, and a second division port of the first inter-frequency power divider is configured to output one second radio frequency signal; and
the combining port of the second inter-frequency power divider is configured to input the first radio frequency signal and the second radio frequency signal, a first division port of the second inter-frequency power divider outputs one first radio frequency signal, and a second division port of the second inter-frequency power divider is configured to output one second radio frequency signal.

17. The multi-way power amplification architecture according to claim 15, wherein the division circuit comprises a third inter-frequency power divider, a third power divider, and a fourth power divider, a first division port and a second division port of the third inter-frequency power divider are respectively coupled to a combining port of the third power divider and a combining port of the fourth power divider, and the third inter-frequency power divider is an inter-frequency power division circuit based on a microstrip line;
a combining port of the third inter-frequency power divider is configured to input the first radio frequency signal and the second radio frequency signal, the first division port of the third inter-frequency power divider is configured to output the first radio frequency signal, and the second division port of the third inter-frequency power divider is configured to output the second radio frequency signal;
a first division port and a second division port of the third power divider are separately configured to output one first radio frequency signal; and
a first division port and a second division port of the fourth power divider are separately configured to output one second radio frequency signal.

18. The multi-way power amplification architecture according to any one of claims 1 to 17, wherein the first radio frequency signal and/or the second radio frequency signal comprises a radio frequency signal of at least one sub-band.

19. The multi-way power amplification architecture according to any one of claims 1 to 18, wherein a minimum operating power point of the first main amplification circuit is less than a minimum operating power point of the first auxiliary amplification circuit and a minimum operating power point of the second auxiliary amplification circuit, a minimum operating power point of the second main amplification circuit is less than the minimum operating power point of the first auxiliary amplification circuit and the minimum operating power point of the second auxiliary amplification circuit, and the minimum operating power point of the first auxiliary amplification circuit is less than, equal to, or greater than the minimum operating power point of the second auxiliary amplification circuit.

20. The multi-way power amplification architecture according to claim 19, wherein the multi-way power amplification architecture further comprises a drive circuit or a control circuit, and the minimum operating power points of the first main amplification circuit, the second main amplification circuit, the first auxiliary amplification circuit, and the second auxiliary amplification circuit are controlled based on the drive circuit or the control circuit.

21. The multi-way power amplification architecture according to any one of claims 1 to 20, wherein at least one of the plurality of microstrip lines is a microstrip line of a three-dimensional stacked structure.

22. A radio frequency generation device, comprising a radio frequency generation circuit and the multi-way power amplification architecture according to any one of claims 1 to 21, wherein the radio frequency generation circuit is configured to output a radio frequency signal to the multi-way power amplification architecture, and the power amplifier is configured to perform power-combining amplification according to the radio frequency signal.

23. A communication system, comprising a baseband processing device and the radio frequency generation device according to claim 22, wherein the baseband processing device is configured to output a baseband signal to the radio frequency generation device, and the radio frequency generation device is configured to obtain a radio frequency signal based on the baseband signal, and perform power-combining amplification on the radio frequency signal.
